# EUROPEAN PATENT APPLICATION

(11) **EP 4 379 407 A1**
(43) Date of publication of application: **05.06.2024**
(21) Application number: 22869608.4
(22) Date of filing: 23.03.2022
(51) Int. Cl.: G01R 31/387, G01R 31/367, G01R 31/3842, H01M 10/48, H02J 7/00, H02J 7/34

(54) **BATTERY CAPACITY ESTIMATION DEVICE, CHARGING PLAN GENERATION DEVICE, DISCHARGING PLAN GENERATION DEVICE, AND BATTERY CAPACITY ESTIMATION METHOD**

(30) Priority: 15.09.2021 JP 2021150401
(71) Applicant: OMRON Corporation, Kyoto 600-8530 (JP)
(72) Inventor: CHEN, Chen, Kyoto-shi, Kyoto 600-8530 (JP); NAGAOKA Shingo, Kyoto-shi, Kyoto 600-8530 (JP); NISHIKAWA, Takeo, Kyoto-shi, Kyoto 600-8530 (JP); OKADA, Wataru, Kyoto-shi, Kyoto 600-8530 (JP); IKEMOTO, Satoru, Tokyo 108-0075 (JP); NAKAI, Takuya, Tokyo 108-0075 (JP)
(74) Representative: Isarpatent
(86) International application number: PCT/JP2022/013580
(87) International publication number: WO 2023/042456

(57) **Abstract**

The battery capacity of a storage battery is estimated without acquiring information on the battery capacity from the storage battery side. A battery capacity estimation device that estimates the battery capacity of a storage battery, the battery capacity estimation device including: a characteristic information acquisition unit configured to acquire the charge characteristic information of the storage battery in which at least one of a charge current, a charge voltage, or a charge power for charging the storage battery is associated with the battery capacity; and a capacity estimation unit configured to perform an estimation process of outputting power of a first output power value to the storage battery over a predetermined time necessary for estimating the battery capacity to perform first charging and estimating the battery capacity on the basis of at least the first output power value.

## Description

### TECHNICAL FIELD

The present invention relates to a battery capacity estimation device that estimates battery capacity of a storage battery, a charge schedule generation device that generates a charge schedule for charging the storage battery, a discharge schedule generation device that generates a discharge schedule for discharging the storage battery, and a battery capacity estimation method that estimates the battery capacity of the storage battery.

### BACKGROUND ART

When a storage battery mounted in a mobile body such as an electric vehicle (EV) is charged, it is necessary to consider various conditions. For example, when a charger charges a storage battery with power supplied from a commercial power system, it is required to minimize the maximum power consumed through the charger. It is also required to complete charging by a predetermined time according to a use purpose of a mobile body on which the storage battery is mounted. Further, it is required to reduce the charge speed in consideration of its impact on the degradation of the storage battery. Moreover, it is required to minimize the idle time after completion of charging.

To charge the storage battery so as to meet such various conditions, a technique has been proposed to acquire information regarding the battery capacity of the storage battery and the state of the storage battery, and perform charge control according to a charge schedule created on the basis of the information (e.g., Patent Document 1).

However, there is a problem that information regarding the state of the storage battery such as the battery capacity cannot necessarily be acquired from the storage battery side.

### PRIOR ART DOCUMENT

### PATENT DOCUMENT

Patent Document 1: Japanese Unexamined Patent Publication No. 2021-65101 (published on April 22, 2021)

### SUMMARY OF THE INVENTION

### PROBLEMS TO BE SOLVED BY THE INVENTION

The present invention has been made in view of the above problems, and an object of the present invention is to provide a technique for estimating the battery capacity of a storage battery even when information on the battery capacity cannot be acquired from the storage battery side.

### MEANS FOR SOLVING THE PROBLEM

The present invention for solving the above problems is a battery capacity estimation device that estimates battery capacity of a storage battery, the battery capacity estimation device including:
a characteristic information acquisition unit configured to acquire charge characteristic information of the storage battery in which at least one of a charge current, a charge voltage, or a charge power for charging the storage battery is associated with the battery capacity; and
a capacity estimation unit configured to perform an estimation process of outputting power of a first output power value to the storage battery over a predetermined time necessary for estimating the battery capacity to perform first charging and estimating the battery capacity on the basis of at least the first output power value.

According to the above, the charge characteristic information in which at least one of a charge current, a charge voltage, or a charge power for charging the storage battery is associated with the battery capacity is acquired, the first output power value is output to the storage battery over a predetermined time necessary for estimating the battery capacity to perform the first charging, and the battery capacity is estimated on the basis of at least the first output power value. Therefore, the battery capacity of the storage battery can be estimated even when the information on the battery capacity cannot be acquired from the storage battery side.

The charge characteristic information is information in which at least one of the charge current, the charge voltage, or the charge power is associated with the battery capacity. The charge characteristic information includes: information in which the charge current and the charge voltage are associated with the battery capacity; information in which the charge current and the charge power are associated with the battery capacity; information in which the charge voltage and the charge power are associated with the battery capacity; and information in which the charge power is associated with the battery capacity.

Here, the battery capacity includes the dischargeable remaining capacity held in the storage battery, but is not limited to the remaining capacity itself, and may be a value derived from the remaining capacity such as a ratio of the remaining capacity to the rated capacity or the maximum allowable amount, or a value (used capacity) obtained by subtracting the remaining capacity from the rated capacity or the maximum allowable amount.

Further, in the present invention,
the characteristic information acquisition unit may acquire first charge characteristic information that is the charge characteristic information in which the charge voltage and the battery capacity are associated with each other when the charge current is held at a predetermined current value, and
the capacity estimation unit may perform a first estimation process of estimating the battery capacity on the basis of the first output power value, the predetermined current value, and the first charge characteristic information.

According to the above, the first charge characteristic information, which is the charge characteristic information with the charge voltage for charging the storage batter and the battery capacity associated with each other, is acquired when the charge current is held at a predetermined current value, and the battery capacity is estimated on the basis of the first output power value, the predetermined current value, and the first charge characteristic information. Therefore, the battery capacity of the storage battery can be estimated even when the information on the battery capacity cannot be acquired from the storage battery side.

Also, in the present invention, the battery capacity estimation device may further include:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a first charge mode in which the charge current is held at the predetermined current value on the basis of a direction of a change in the second output power value, and
the capacity estimation unit may perform the first estimation process when the first charge mode is determined.

In this way, the mode for charging the storage battery can be determined on the basis of the direction of the change, in the second output power value during the second charging. When the mode for charging the storage battery is the first charge mode, the charge current value is known. Since the first output power value during the first charging is a predetermined value, the presence of the first charge characteristic information of the storage battery, in which the charge voltage and the battery capacity in the first charge mode are associated with each other, enables the battery capacity to be estimated from the first output power value, the charge current value, and the charge characteristic information. As described above, even when the information on the battery capacity cannot be acquired from the storage battery side, the battery capacity of the storage battery can be estimated.

Further, in the present invention,
the characteristic information acquisition unit may acquire second charge characteristic information that is the charge characteristic information in which the charge current and the battery capacity are associated with each other when the charge voltage is held at a predetermined voltage value, and
the capacity estimation unit may perform a second estimation process of estimating the battery capacity on the basis of the first output power value, the predetermined voltage value, and the second charge characteristic information.

According to the above, the second charge characteristic information, which is the charge characteristic information with the charge current and the battery capacity associated with each other, is acquired when the charge voltage is held at a predetermined voltage value, and the battery capacity is estimated on the basis of the first output power value, the predetermined voltage value, and the second charge characteristic information. Therefore, the battery capacity of the storage battery can be estimated even when the information on the battery capacity cannot be acquired from the storage battery side.

Also, in the present invention, the battery capacity estimation device may further include:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a second charge mode in which the charge voltage is held at the predetermined voltage value on the basis of a direction of a change in the second output power value, and
the capacity estimation unit may perform the second estimation process when the second charge mode is determined.

In this way, the mode for charging the storage battery can be determined on the basis of the direction of the change, in the second output power value during the second charging. When the mode for charging the storage battery is the second charge mode, the charge voltage value is known. Since the first output power value during the first charging is a predetermined value, in the case of the second charge mode, the presence of the second charge characteristic information of the storage battery, in which the charge current and the battery capacity in the second charge mode are associated with each other, enables the battery capacity to be estimated on the basis of the first output voltage value, the charge voltage value, and the charge characteristic information. As described above, even when the information on the battery capacity cannot be acquired from the storage battery side, the battery capacity of the storage battery can be estimated.

Further, in the present invention,
the characteristic information acquisition unit may acquire second charge characteristic information that is the charge characteristic information in which the charge current and the battery capacity are associated with each other when the charge voltage is held at a predetermined voltage value, and
the capacity estimation unit may perform a second estimation process of estimating the battery capacity on the basis of the first output power value, the predetermined voltage value, and the second charge characteristic information.

According to the above, the second charge characteristic information, which is the charge characteristic information with the charge current and the battery capacity associated with each other, is acquired when the charge voltage is held at a predetermined voltage value, and the battery capacity is estimated on the basis of the first output power value, the predetermined voltage value, and the second charge characteristic information. Therefore, the battery capacity of the storage battery can be estimated even when the information on the battery capacity cannot be acquired from the storage battery side.

The battery capacity estimation device may further include:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a second charge mode in which the charge voltage is held at the predetermined voltage value on the basis of a direction of a change in the second output power value, and
the capacity estimation unit may perform the second estimation process when the second charge mode is determined.

In this way, the mode for charging the storage battery can be determined on the basis of the direction of the change, in the second output power value during the second charging. When the mode for charging the storage battery is the second charge mode, the charge voltage value is known. Since the first output power value during the first charging is a predetermined value, when the presence of the second charge characteristic information of the storage battery, in which the charge current and the battery capacity in the second charge mode are associated with each other, enables the battery capacity to be estimated on the basis of the first output voltage value, the charge voltage value, and the charge characteristic information. As described above, even when the information on the battery capacity cannot be acquired from the storage battery side, the battery capacity of the storage battery can be estimated.

Also, in the present invention, the battery capacity estimation device may further include:
a second output power value acquisition unit configured to acquire a second output power value that is output to the storage battery in second charging in which the storage battery is charged over a predetermined time necessary for determining a charge mode for charging the storage battery; and
a mode determination unit configured to determine whether the charge mode is a first charge mode in which the charge current is held at the predetermined current value or a second charge mode in which the charge voltage is held at the predetermined voltage value on the basis of a direction of a change in the second output power value, and
the capacity estimation unit may perform the first estimation process when the first charge mode is determined, and performs the second estimation process when the second charge mode is determined.

According to the above, the mode for charging the storage battery can be determined on the basis of the direction of the change in the second output power value during the second charging. When the charge mode for charging the storage battery is the second charge mode, the charge voltage value is known, and when the charge mode is the first charge mode, the charge current value is known. Since the first output power value during the first charging is a predetermined value, the presence of the second charge characteristic information of the storage battery, in which the charge current and the battery capacity in the second charge mode are associated with each other, enables the battery capacity to be estimated on the basis of the first output voltage value, the charge voltage value, and the second charge characteristic information when the second charge mode is determined, and the presence of the first charge characteristic information of the storage battery, in which the charge voltage and the battery capacity in the first charge mode are associated with each other, enables the battery capacity to be estimated on the basis of the first output power value, the charge current value, and the first charge characteristic information when the first charge mode is determined. As described above, even when the information on the battery capacity cannot be acquired from the storage battery side, the battery capacity of the storage battery can be estimated.

Also, in the present invention,
the characteristic information acquisition unit may acquire second charge characteristic information that is the charge characteristic information in which the charge current and the battery capacity are associated with each other when the charge voltage is held at a predetermined voltage value,
the capacity estimation unit may perform a second estimation process of estimating the battery capacity on the basis of the first output power value, the predetermined voltage value, and the second charge characteristic information,
the battery capacity estimation device may further include:
   a second output power value acquisition unit configured to acquire a second output power value that is output to the storage battery in second charging in which the storage battery is charged over a predetermined time necessary for determining a charge mode for charging the storage battery; and
   a mode determination unit configured to determine that the charge mode is a first charge mode in which the charge current is held at the predetermined current value on the basis of a direction of a change in the second output power value, and
   the capacity estimation unit may perform the first estimation process when the first charge mode is determined.

According to the above, the second charge characteristic information, which is the charge characteristic information with the charge current and the battery capacity associated with each other, can be acquired when the charge voltage is held at a predetermined voltage value, and the battery capacity can be estimated on the basis of the first output power value, the predetermined voltage value, and the second charge characteristic information. Further, the mode for charging the storage battery can be determined on the basis of the direction of the change, in the second output power value during the second charging. Since the first estimation process is performed when the first charge mode is determined, the battery capacity of the storage battery can be estimated even when the information on the battery capacity cannot be acquired from the storage battery side.

Also, in the present invention, the battery capacity estimation device may further include
a characteristic identification information acquisition unit configured to acquire characteristic identification information associated with each of a plurality of pieces of the charge characteristic information, and
the characteristic information acquisition unit may acquire the charge characteristic information specified by the characteristic identification information.

According to the above, even for storage batteries having different charge characteristics, when a device such as a storage battery or an EV mounted with the storage battery holds the characteristic identification information, the battery capacity can be appropriately estimated for the storage batteries having different charge characteristics by acquiring the characteristic identification information.

Further, the present invention relates to a charge schedule generation device that generates a charge schedule for charging a storage battery, the charge schedule generation device including:
a characteristic information acquisition unit configured to acquire charge characteristic information of the storage battery in which at least one of a charge current, a charge voltage, or a charge power for charging the storage battery is associated with battery capacity of the storage battery;
a capacity estimation unit configured to perform an estimation process of outputting power of a first output power value to the storage battery over a predetermined time necessary for estimating the battery capacity to perform first charging and estimating the battery capacity on the basis of at least the first output power value;
a condition acquisition unit configured to acquire a condition related to a charge time for charging the storage battery and/or a condition including a target power to be a target during charging; and
a charge schedule generation unit configured to generate a charge schedule on the basis of the battery capacity estimated and the condition.

According to the above, the charge characteristic information in which at least one of a charge current, a charge voltage, or a charge power for charging the storage battery is associated with the battery capacity is acquired, the first output power value is output to the storage battery over a predetermined time necessary for estimating the battery capacity to perform the first charging, and the battery capacity is estimated on the basis of at least the first output power value. Therefore, the battery capacity of the storage battery can be estimated even when the information on the battery capacity cannot be acquired from the storage battery side. By generating a charge schedule for the storage battery on the basis of the battery capacity estimated in this manner and the condition related to the charge time for charging the storage battery and/or the condition including the target power as a target curing charging, it is possible to generate an appropriate charge schedule even when information on the battery capacity cannot be acquired from the storage battery side.

Also, in the present invention,
the condition related to the charge time may include setting, as the charge time, an entire period of a chargeable time that is a time during which each of a plurality of the storage batteries is chargeable, and
the condition related to the target power may include that a total of the charge power of the plurality of the storage batteries over the entire period of the chargeable time does not exceed an upper limit value.

According to the above, since each of the plurality of storage batteries is charged over the entire period of the chargeable time, it is possible to charge the storage battery as slowly as possible to shorten the time when the battery is fully charged in a state where the charging is complete, and it is possible to generate a charge schedule capable of preventing the degradation of the storage battery. In addition, since charging is performed so that the total value of the charge power of the plurality of storage batteries in the entire period of the chargeable period does not exceed the upper limit value, it is possible to generate a charge schedule capable of reducing the total value of the charge power of the plurality of storage batteries.

Further, in the present invention,
the characteristic information acquisition unit may acquire first charge characteristic information that is the charge characteristic information in which the charge voltage and the battery capacity are associated with each other when the charge current is held at a predetermined current value, and
the capacity estimation unit may perform a first estimation process of estimating the battery capacity on the basis of the first output power value, the predetermined current value, and the first charge characteristic information.

Also, in the present invention, the battery capacity estimation device may further include:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a first charge mode in which the charge current is held at the predetermined current value on the basis of a direction of a change in the second output power value, and
the capacity estimation unit may perform the first estimation process when the first charge mode is determined.

Further, in the present invention,
the characteristic information acquisition unit may acquire second charge characteristic information that is the charge characteristic information in which the charge current and the battery capacity are associated with each other when the charge voltage is held at a predetermined voltage value, and
the capacity estimation unit may perform a second estimation process of estimating the battery capacity on the basis of the first output power value, the predetermined voltage value, and the second charge characteristic information.

Also, in the present invention, the battery capacity estimation device may further include:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a second charge mode in which the charge voltage is held at the predetermined voltage value on the basis of a direction of a change in the second output power value, and
the capacity estimation unit may perform the second estimation process when the second charge mode is determined.

Further, in the present invention,
the characteristic information acquisition unit may acquire second charge characteristic information that is the charge characteristic information in which the charge current and the battery capacity are associated with each other when the charge voltage is held at a predetermined voltage value, and
the capacity estimation unit may perform a second estimation process of estimating the battery capacity on the basis of the first output power value, the predetermined voltage value, and the second charge characteristic information.

Also, in the present invention, the battery capacity estimation device may further include:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a second charge mode in which the charge voltage is held at the predetermined voltage value on the basis of a direction of a change in the second output power value, and
the capacity estimation unit may perform the second estimation process when the second charge mode is determined.

Also, in the present invention, the battery capacity estimation device may further include:
a second output power value acquisition unit configured to acquire a second output power value that is output to the storage battery in second charging in which the storage battery is charged over a predetermined time necessary for determining a charge mode for charging the storage battery; and
a mode determination unit configured to determine whether the charge mode is a first charge mode in which the charge current is held at the predetermined current value or a second charge mode in which the charge voltage is held at the predetermined voltage value on the basis of a direction of a change in the second output power value, and
the capacity estimation unit may perform the first estimation process when the first charge mode is determined, and performs the second estimation process when the second charge mode is determined.

Further, the present invention relates to a charge schedule generation device that generates a charge schedule for charging a storage battery, the charge schedule generation device including:
a characteristic information acquisition unit configured to acquire discharge characteristic information of the storage battery in which at least one of a discharge current, a discharge voltage, or a discharge power discharged from the storage battery is associated with battery capacity of the storage battery;
a third output power value acquisition unit configured to acquire a third output power value output from the storage battery in first discharging in which the storage battery is discharged over a predetermined time necessary for estimating the battery capacity;
a capacity estimation unit configured to perform an estimation process of estimating the battery capacity on the basis of at least the third output power value;
a condition acquisition unit configured to acquire a condition related to a charge time for charging the storage battery and/or a condition including a target power to be a target during charging; and
a charge schedule generation unit configured to generate a charge schedule on the basis of the battery capacity estimated and the condition.

According to the above, the discharge characteristic information in which at least one of the discharge current, the discharge voltage, or the discharge power discharged from the storage battery is associated with the battery capacity is acquired, and the battery capacity is estimated on the basis of at least the third output power value output from the storage battery in the first discharging in which the battery is discharged over a predetermined time necessary for estimating the battery capacity. Therefore, the battery capacity of the storage battery can be estimated even when the information on the battery capacity cannot be acquired from the storage battery side. By generating a charge schedule for the storage battery on the basis of the battery capacity estimated in this manner and the condition related to the charge time for charging the storage battery and/or the condition including the target power as a target curing charging, it is possible to generate an appropriate charge schedule even when information on the battery capacity cannot be acquired from the storage battery side.

Further, the present invention relates to a battery capacity estimation method for estimating battery capacity of a storage battery, the method including:
a charge characteristic information acquisition step of acquiring charge characteristic information of the storage battery in which at least one of a charge current, a charge voltage, or a charge power for charging the storage battery is associated with the battery capacity;
a first charge step of outputting power of a first output power value to the storage battery over a predetermined time necessary for estimating the battery capacity to perform first charging; and
a capacity estimation step of performing an estimation process of estimating the battery capacity on the basis of at least the first output power value.

According to the above, the charge characteristic information in which at least one of a charge current, a charge voltage, or a charge power for charging the storage battery is associated with the battery capacity is acquired, the first output power value is output to the storage battery over a predetermined time necessary for estimating the battery capacity to perform the first charging, and the battery capacity is estimated on the basis of at least the first output power value. Therefore, the battery capacity of the storage battery can be estimated even when the information on the battery capacity cannot be acquired from the storage battery side.

Also, in the present invention,
the charge characteristic information acquisition step may include a step of acquiring first charge characteristic information of the storage battery in which the charge voltage and the battery capacity are associated with each other when a charge current for charging the storage battery is held at a predetermined current value, and
the capacity estimation step may include a first estimation process step of estimating the battery capacity on the basis of the first output power value, the predetermined current value, and the first charge characteristic information.

Also, in the present invention, the battery capacity estimation device may further include:
a step of acquiring a second output power value that is output to the storage battery in second charging in which the storage battery is charged over a predetermined time necessary for determining a charge mode for charging the storage battery; and
a mode determination step of determining that the charge mode is a first charge mode in which the charge current is held at the predetermined current value on the basis of a direction of a change in the second output power value, and
the first charge step and the first estimation process step may be executed when the first charge mode is determined, and the first charge step and the second estimation process step may be executed when the constant voltage mode is determined.

Also, in the present invention,
the charge characteristic information acquisition step may include a step of acquiring second charge characteristic information of the storage battery in which the charge current and the battery capacity are associated with each other when the charge voltage is held at a predetermined voltage value, and
the capacity estimation step may include a second estimation process step of estimating the battery capacity on the basis of the first output power value, the predetermined voltage value, and the second charge characteristic information.

Also, in the present invention, the battery capacity estimation method may further include:
a step of acquiring a second output power value that is output to the storage battery in second charging in which the storage battery is charged over a predetermined time necessary for determining a charge mode for charging the storage battery; and
a mode determination step of determining that the charge mode is a second charge mode in which the charge voltage is held at the predetermined voltage value on the basis of a direction of a change in the second output power value, and
the second estimation process may be executed when the second charge mode is determined.

Also, in the present invention,
the charge characteristic information acquisition step may include a step of acquiring second charge characteristic information of the storage battery in which the charge current and the battery capacity are associated with each other when the charge voltage is held at a predetermined voltage value, and
the capacity estimation step may include a second estimation process step of estimating the battery capacity on the basis of the first output power value, the predetermined voltage value, and the second charge characteristic information.

Also, in the present invention, the battery capacity estimation method may further include:
a step of acquiring a second output power value that is output to the storage battery in second charging in which the storage battery is charged over a predetermined time necessary for determining a charge mode for charging the storage battery; and
a mode determination step of determining that the charge mode is a second charge mode in which the charge voltage is held at the predetermined voltage value on the basis of a direction of a change in the second output power value, and
the second estimation process may be executed when the second charge mode is determined.

Also, in the present invention, the battery capacity estimation device may further include:
a step of acquiring a second output power value that is output to the storage battery in second charging in which the storage battery is charged over a predetermined time necessary for determining a charge mode for charging the storage battery; and
a mode determination step configured to determine whether the charge mode is a first charge mode in which the charge current is held at the predetermined current value or a second charge mode in which the charge voltage is held at the predetermined voltage value on the basis of a direction of a change in the second output power value, and
the first charge step and the first estimation process step may be executed when the first charge mode is determined, and the first charge step and the second estimation process step may be executed when the second charge mode is determined.

The present invention is a battery capacity estimation device that estimates battery capacity of a storage battery, the battery capacity estimation device including:
a characteristic information acquisition unit configured to acquire discharge characteristic information of the storage battery in which at least one of a discharge current, a discharge voltage, or a discharge power discharged from the storage battery is associated with the battery capacity;
a third output power value acquisition unit configured to acquire a third output power value output from the storage battery in first discharging in which the storage battery is discharged over a predetermined time necessary for estimating the battery capacity; and
a capacity estimation unit configured to perform an estimation process of estimating the battery capacity on the basis of at least the third output power value.

According to the above, the discharge characteristic information in which at least one of the discharge current, the discharge voltage, or the discharge power discharged from the storage battery is associated with the battery capacity is acquired, and the battery capacity is estimated on the basis of at least the third output power value output from the storage battery in the first discharging in which the battery is discharged over a predetermined time necessary for estimating the battery capacity. Therefore, the battery capacity of the storage battery can be estimated even when the information on the battery capacity cannot be acquired from the storage battery side.

The discharge characteristic information is information in which at least one of the discharge current, the discharge voltage, or the discharge power is associated with the battery capacity. The discharge characteristic information includes: information in which the discharge current and the discharge voltage are associated with the battery capacity; information in which the discharge current and the discharge power are associated with the battery capacity; information in which the discharge voltage and the discharge power are associated with the battery capacity; and information in which the discharge power is associated with the battery capacity. Here, the battery capacity includes the dischargeable remaining capacity held in the storage battery, but is not limited to the remaining capacity itself, and may be a value derived from the remaining capacity such as a ratio of the remaining capacity to the rated capacity or the maximum allowable amount, or a value (used capacity) obtained by subtracting the remaining capacity from the rated capacity or the maximum allowable amount.

Further, in the present invention,
the characteristic information acquisition unit may acquire first discharge characteristic information that is the discharge characteristic information in which the discharge voltage and the battery capacity are associated with each other when the discharge current is held at a predetermined current value, and
the capacity estimation unit may perform a third estimation process of estimating the battery capacity on the basis of the third output power value, the predetermined current value, and the first discharge characteristic information.

According to the above, the first discharge characteristic information, which is the discharge characteristic information with the discharge voltage and the battery capacity associated with each other, is acquired when the discharge current is held at the predetermined current value, and the battery capacity is estimated on the basis of the third output power value, the predetermined current value, and the first discharge characteristic information. Therefore, the battery capacity of the storage battery can be estimated even when the information on the battery capacity cannot be acquired from the storage battery side.

Also, in the present invention, the battery capacity estimation device may further include:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a first discharge mode in which the discharge current is held at the predetermined current value, and
the capacity estimation unit may perform the third estimation process when the first discharge mode is determined.

According to the above, the discharge mode for discharging the storage battery can be determined by comparing the first output current value with the predetermined threshold. When the discharge mode for discharging the storage battery is the first discharge mode, the discharge current value is known. Since the third output power value id known, the presence of the first discharge characteristic information, in which the discharge voltage and the battery capacity in the first discharge mode are associated with each other, enables the battery capacity to be estimated from the third output power value, the discharge current value, and the first discharge characteristic information. As described above, even when the information on the battery capacity cannot be acquired from the storage battery side, the battery capacity of the storage battery can be estimated.

Further, in the present invention,
the characteristic information acquisition unit may acquire second discharge characteristic information that is the discharge characteristic information in which the discharge current and the battery capacity are associated with each other when the discharge voltage is held at a predetermined voltage value, and
the capacity estimation unit may perform a fourth estimation process of estimating the battery capacity on the basis of the third output power value, the predetermined voltage value, and the second discharge characteristic information.

According to the above, the second discharge characteristic information, which is the discharge characteristic information with the discharge current and the battery capacity associated with each other, is acquired when the discharge voltage is held at the predetermined voltage, and the battery capacity is estimated on the basis of the third power output value, the predetermined voltage value, and the second discharge characteristic information. Therefore, the battery capacity of the storage battery can be estimated even when the information on the battery capacity cannot be acquired from the storage battery side.

Also, in the present invention, the battery capacity estimation device may further include:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a second discharge mode in which the discharge voltage is held at the predetermined voltage value, and
the capacity estimation unit performs the fourth estimation process when the second discharge mode is determined.

According to the above, the discharge mode for discharging the storage battery can be determined by comparing the first output current value with the predetermined threshold. When the discharge mode for discharging the storage battery is the second discharge mode, the discharge voltage value is known. Since the third output power value id known, the presence of the second discharge characteristic information, in which the discharge current and the battery capacity in the second discharge mode are associated with each other, enables the battery capacity to be estimated from the third output power value, the discharge voltage value, and the second discharge characteristic information. As described above, even when the information on the battery capacity cannot be acquired from the storage battery side, the battery capacity of the storage battery can be estimated.

Further, in the present invention,
the characteristic information acquisition unit may acquire second discharge characteristic information that is the discharge characteristic information in which the discharge current and the battery capacity are associated with each other when the discharge voltage is held at a predetermined voltage value, and
the capacity estimation unit may perform a fourth estimation process of estimating the battery capacity on the basis of the third output power value, the predetermined voltage value, and the second discharge characteristic information.

According to the above, the second discharge characteristic information, which is the discharge characteristic information with the discharge current and the battery capacity associated with each other, is acquired when the discharge voltage is held at the predetermined voltage value, and the battery capacity is estimated on the basis of the third power output value, the predetermined voltage value, and the second discharge characteristic information. Therefore, the battery capacity of the storage battery can be estimated even when the information on the battery capacity cannot be acquired from the storage battery side.

Also, in the present invention, the battery capacity estimation device may further include:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a second discharge mode in which the discharge voltage is held at the predetermined voltage value, and
the capacity estimation unit performs the fourth estimation process when the second discharge mode is determined.

According to the above, the discharge mode for discharging the storage battery can be determined by comparing the first output current value with the predetermined threshold. When the discharge mode for discharging the storage battery is the second discharge mode, the discharge voltage value is known. Since the third output power value id known, the presence of the second discharge characteristic information, in which the discharge current and the battery capacity in the second discharge mode are associated with each other, enables the battery capacity to be estimated from the third output power value, the discharge voltage value, and the second discharge characteristic information. As described above, even when the information on the battery capacity cannot be acquired from the storage battery side, the battery capacity of the storage battery can be estimated.

Also, in the present invention, the battery capacity estimation device may further include:
a first output current value acquisition unit configured to acquire a first output current value output from the storage battery in second discharging for discharging the storage battery, over a predetermined time required to determine a discharge mode for discharging the storage battery; and
a mode determination unit configured to compare the first output current value with a predetermined threshold and determine whether the discharge mode is a first discharge mode in which the discharge current is held at the predetermined current value or a second discharge mode in which the discharge voltage is held at the predetermined voltage value, and
the capacity estimation unit performs the third estimation process when the first discharge mode is determined, and performs the fourth estimation process when the second discharge mode is determined.

According to the above, the discharge mode for discharging the storage battery can be determined by comparing the first output current value with the predetermined threshold. When the discharge mode for discharging the storage battery is the second discharge mode, the discharge voltage is known, and when the discharge mode is the first discharge mode, the discharge current value is known. Since the third output power value during the second discharging is known, in the case of the second discharge mode, the presence of the second discharge characteristic information, in which the discharge current and the battery capacity in the second discharge mode are associated with each other, enables the battery capacity to be estimated on the basis of the third output power value, the discharge voltage value, and the second discharge characteristic information, and in the case of the first discharge mode, the presence of the first discharge characteristic information, in which the discharge voltage and the battery capacity in the first discharge mode are associated with each other, enables the battery capacity to be estimated on the basis of the third output power value, the discharge current value, and the first discharge characteristic information. As described above, even when the information on the battery capacity cannot be acquired from the storage battery side, the battery capacity of the storage battery can be estimated.

Also, in the present invention,
the characteristic information acquisition unit may acquire second discharge characteristic information that is the discharge characteristic information in which the discharge current and the battery capacity are associated with each other when the discharge voltage is held at a predetermined voltage value,
the capacity estimation unit may perform a fourth estimation process of estimating the battery capacity on the basis of the third output power value, the predetermined voltage value, and the second discharge characteristic information,
the battery capacity estimation device may further include:
   a first output current value acquisition unit configured to acquire a first output current value output from the storage battery in second discharging in which the storage battery is discharged over a predetermined time necessary for determining a discharge mode for discharging the storage battery; and
   a mode determination unit configured to compare the first output current value with a predetermined threshold and determine that the discharge mode is a first discharge mode in which the discharge current is held at the predetermined current value, and
   the capacity estimation unit may perform the third estimation process when the first discharge mode is determined.

According to the above, the second discharge characteristic information, which is the discharge characteristic information with the discharge current and the battery capacity associated with each other, is acquired when the discharge voltage is held at the predetermined voltage value, and the battery capacity can be estimated on the basis of the third power output value, the predetermined voltage value, and the second discharge characteristic information. The discharge mode for discharging the storage battery can be determined by comparing the first output current value with the predetermined threshold. Since the third estimation process is performed when the first discharge mode is determined, the battery capacity of the storage battery can be estimated even when the information on the battery capacity cannot be acquired from the storage battery side.

Also, in the present invention, the battery capacity estimation device may further include
a characteristic identification information acquisition unit configured to acquire characteristic identification information associated with each of a plurality of pieces of the discharge characteristic information, and
the characteristic information acquisition unit may acquire the discharge characteristic information specified by the characteristic identification information.

According to the above, even for storage batteries having different charge characteristics, when a device such as a storage battery or an EV mounted with the storage battery holds the characteristic identification information, the battery capacity can be appropriately estimated for the storage batteries having different discharge characteristics by acquiring the characteristic identification information.

The present invention is a discharge schedule generation device that generates a discharge schedule for discharging a storage battery, the discharge schedule generation device including:
a characteristic information acquisition unit configured to acquire discharge characteristic information of the storage battery in which at least one of a discharge current, a discharge voltage, or a discharge power discharged from the storage battery is associated with battery capacity of the storage battery;
a third output power value acquisition unit configured to acquire a third output power value output from the storage battery in first discharging in which the storage battery is discharged over a predetermined time necessary for estimating the battery capacity;
a capacity estimation unit configured to perform an estimation process of estimating the battery capacity on the basis of at least the third output power value;
a condition acquisition unit configured to acquire a condition related to a discharge time for discharging the storage battery and/or a condition including a target power to be a target during discharging; and
a discharge schedule generation unit configured to generate a discharge schedule on the basis of the battery capacity estimated and the condition.

According to the above, the discharge characteristic information in which at least one of the discharge current, the discharge voltage, or the discharge power discharged from the storage battery is associated with the battery capacity is acquired, and the battery capacity is estimated on the basis of at least the third output power value output from the storage battery in the first discharging in which the storage battery is discharged over a predetermined time necessary for estimating the battery capacity. Therefore, the battery capacity of the storage battery can be estimated even when the information on the battery capacity cannot be acquired from the storage battery side. By generating a discharge schedule for the storage battery on the basis of the battery capacity estimated in this manner and the condition related to the discharge time for discharging the storage battery and/or the condition including the target power as a target curing discharging, it is possible to generate an appropriate discharge schedule even when information on the battery capacity cannot be acquired from the storage battery side.

Further, in the present invention,
the characteristic information acquisition unit may acquire first discharge characteristic information that is the discharge characteristic information in which the discharge voltage and the battery capacity are associated with each other when the discharge current is held at a predetermined current value, and
the capacity estimation unit may perform a third estimation process of estimating the battery capacity on the basis of the third output power value, the predetermined current value, and the first discharge characteristic information.

Also, in the present invention, the battery capacity estimation device may further include:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a first discharge mode in which the discharge current is held at the predetermined current value, and
the capacity estimation unit may perform the third estimation process when the first discharge mode is determined.

Further, in the present invention,
the characteristic information acquisition unit may acquire second discharge characteristic information that is the discharge characteristic information in which the discharge current and the battery capacity are associated with each other when the discharge voltage is held at a predetermined voltage value, and
the capacity estimation unit may perform a fourth estimation process of estimating the battery capacity on the basis of the third output power value, the predetermined voltage value, and the second discharge characteristic information.

Also, in the present invention, the battery capacity estimation device may further include:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a second discharge mode in which the discharge voltage is held at the predetermined voltage value, and
the capacity estimation unit performs the fourth estimation process when the second discharge mode is determined.

Further, in the present invention,
the characteristic information acquisition unit may acquire second discharge characteristic information that is the discharge characteristic information in which the discharge current and the battery capacity are associated with each other when the discharge voltage is held at a predetermined voltage value, and
the capacity estimation unit may perform a fourth estimation process of estimating the battery capacity on the basis of the third output power value, the predetermined voltage value, and the second discharge characteristic information.

In the present invention, the battery capacity estimation further may further include:
a first output current value acquisition unit configured to acquire a first output current value that is an output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a second discharge mode in which the discharge voltage is held at the predetermined voltage value, and
the capacity estimation unit may perform the fourth estimation process when the second discharge mode is determined.

Also, in the present invention, the battery capacity estimation device may further include:
a first output current value acquisition unit configured to acquire a first output current value output from the storage battery in second discharging for discharging the storage battery, over a predetermined time required to determine a discharge mode for discharging the storage battery; and
a mode determination unit configured to compare the first output current value with a predetermined threshold and determine whether the discharge mode is a first discharge mode in which the discharge current is held at the predetermined current value or a second discharge mode in which the discharge voltage is held at the predetermined voltage value, and
the capacity estimation unit performs the third estimation process when the first discharge mode is determined, and performs the fourth estimation process when the second discharge mode is determined.

Further, in the present invention,
the characteristic information acquisition unit may acquire second discharge characteristic information that is the discharge characteristic information in which the discharge current and the battery capacity are associated with each other when the discharge voltage is held at a predetermined voltage value, and
the capacity estimation unit may perform a fourth estimation process of estimating the battery capacity on the basis of the third output power value, the predetermined voltage value, and the second discharge characteristic information.

Further, the present invention relates to a discharge schedule generation device that generates a discharge schedule for discharging a storage battery, the discharge schedule generation device including:
a characteristic information acquisition unit configured to acquire charge characteristic information of the storage battery in which at least one of a charge current, a charge voltage, or a charge power for charging the storage battery is associated with battery capacity of the storage battery;
a capacity estimation unit configured to perform an estimation process of outputting power of a first output power value to the storage battery over a predetermined time necessary for estimating the battery capacity to perform first charging and estimating the battery capacity on the basis of at least the first output power value;
a condition acquisition unit configured to acquire a condition related to a discharge time for discharging the storage battery and/or a condition including a target power to be a target during discharging; and
a discharge schedule generation unit configured to generate a discharge schedule on the basis of the battery capacity estimated and the condition.

According to the above, the charge characteristic information in which at least one of a charge current, a charge voltage, or a charge power for charging the storage battery is associated with the battery capacity is acquired, the first output power value is output to the storage battery over a predetermined time necessary for estimating the battery capacity to perform the first charging, and the battery capacity is estimated on the basis of at least the first output power value. Therefore, the battery capacity of the storage battery can be estimated even when the information on the battery capacity cannot be acquired from the storage battery side. By generating a discharge schedule for the storage battery on the basis of the battery capacity estimated in this manner and the condition related to the discharge time for discharging the storage battery and/or the condition including the target power as a target curing discharging, it is possible to generate an appropriate discharge schedule even when information on the battery capacity cannot be acquired from the storage battery side.

Further, the present invention relates to a battery capacity estimation method for estimating battery capacity of a storage battery, the battery capacity estimation method including:
a discharge characteristic information acquisition step of acquiring discharge characteristic information of the storage battery in which at least one of a discharge current, a discharge voltage, or a discharge power for discharging the storage battery is associated with the battery capacity;
a first discharge step of discharging the storage battery over a predetermined time necessary for estimating the battery capacity;
a third output power value acquisition step of acquiring a third output power value output from the storage battery in the first discharge step; and
a capacity estimation step of performing at least an estimation process of estimating the battery capacity on the basis of the third output power value.

According to the above, the discharge characteristic information in which at least one of the discharge current, the discharge voltage, or the discharge power discharged from the storage battery is associated with the battery capacity is acquired, and the battery capacity is estimated on the basis of at least the third output power value output from the storage battery in the first discharging in which the storage battery is discharged over a predetermined time necessary for estimating the battery capacity. Therefore, the battery capacity of the storage battery can be estimated even when the information on the battery capacity cannot be acquired from the storage battery side.

Also, in the present invention,
the discharge characteristic information acquisition step may include a step of acquiring first discharge characteristic information of the storage battery in which the discharge voltage and the battery capacity are associated with each other when a discharge current for discharging the storage battery is held at a predetermined current value, and
the capacity estimation step may include a third estimation process step of estimating the battery capacity on the basis of the third output power value, the predetermined current value, and the first discharge characteristic information.

Also, in the present invention, the battery capacity estimation device may further include:
a step of acquiring a first output current value output from the storage battery in second discharging in which the battery is discharged over a predetermined time necessary for determining a discharge mode for discharging the storage battery; and
a mode determination step of comparing the first output current value with a predetermined threshold and determining that the discharge mode is a first discharge mode in which the discharge current is held at the predetermined current value, and
the first discharge step and the third estimation process step may be executed when the first discharge mode is determined.

Also, in the present invention,
the discharge characteristic information acquisition step may include a step of acquiring second discharge characteristic information that is discharge characteristic information in which the discharge current and the battery capacity are associated with each other when the discharge voltage is held at a predetermined voltage value, and
the capacity estimation step may include a fourth estimation process step of estimating the battery capacity on the basis of the third output power value, the predetermined voltage value, and the second discharge characteristic information.

Also, in the present invention, the battery capacity estimation device may further include:
a step of acquiring a first output current value output from the storage battery in second discharging in which the storage battery is discharged over a predetermined time necessary for determining a discharge mode for discharging the storage battery; and
a mode determination step of comparing the first output current value with a predetermined threshold and determining that the discharge mode is a second discharge mode in which the discharge voltage is held at the predetermined voltage value, and
the fourth estimation process step may be executed when the second discharge mode is determined.

Also, in the present invention,
the discharge characteristic information acquisition step may include a step of acquiring second discharge characteristic information that is discharge characteristic information in which the discharge current and the battery capacity are associated with each other when the discharge voltage is held at a predetermined voltage value, and
the capacity estimation step may include a fourth estimation process step of estimating the battery capacity on the basis of the third output power value, the predetermined voltage value, and the second discharge characteristic information.

Also, in the present invention, the battery capacity estimation device may further include:
a step of acquiring a first output current value output from the storage battery in second discharging in which the storage battery is discharged over a predetermined time necessary for determining a discharge mode for discharging the storage battery; and
a mode determination step of comparing the first output current value with a predetermined threshold and determining that the discharge mode is a second discharge mode in which the discharge voltage is held at the predetermined voltage value, and
the fourth estimation process step may be executed when the second discharge mode is determined.

Also, in the present invention, the battery capacity estimation device may further include:
a step of acquiring a first output current value that is an output current value output from the storage battery in second discharging in which the storage battery is discharged over a predetermined time necessary for determining a discharge mode for discharging the storage battery; and
a mode determination step of comparing the first output current value with a predetermined threshold and determining whether the discharge mode is a first discharge mode in which the discharge current is held at the predetermined current value or a second discharge mode in which the discharge voltage is held at the predetermined voltage value, and
when the first discharge mode is determined, the first discharge step and the third estimation process step may be executed, and when the second discharge mode is determined, the first discharge step and the fourth estimation process step may be executed.

Also, in the present invention,
the discharge characteristic information acquisition step may include a step of acquiring second discharge characteristic information that is discharge characteristic information in which the discharge current and the battery capacity are associated with each other when the discharge voltage is held at a predetermined voltage value, and
the capacity estimation step may include a fourth estimation process step of estimating the battery capacity on the basis of the third output power value, the predetermined voltage value, and the second discharge characteristic information.

Further, the present invention can also be configured as a battery capacity estimation device that estimates battery capacity of a storage battery, the battery capacity estimation device including:
a second output power value acquisition unit configured to acquire a second output power value that is output to the storage battery in second charging in which the storage battery is charged over a predetermined time;
a mode determination unit configured to determine whether a charge mode for charging the storage battery is a constant voltage mode for holding a charge voltage at a predetermined voltage value or a constant current mode for holding a charge current at a predetermined current value on the basis of a direction of a change in the second output power value;
a characteristic information acquisition unit configured to associate the charge current with the battery capacity in the constant voltage mode, and acquire charge characteristic information of the storage battery in which the charge voltage and the battery capacity in the constant current mode are associated with each other; and
a capacity estimation unit configured to output power of a first output power value to the storage battery over a predetermined time to perform second charging, configured to estimate the battery capacity on the basis of a charge current value, calculated from the first output power value and the predetermined voltage value, and the charge characteristic information when the constant voltage mode is determined, and configured to estimate the battery capacity on the basis of a charge voltage value, calculated from the first output power value and the predetermined current value, and the charge characteristic information when the constant current mode is determined.

According to the above, the mode for charging the storage battery can be determined on the basis of the direction of the change in the second output power value during the second charging. When the mode for charging the storage battery is the constant voltage mode, the charge voltage value is known, and when the mode is the constant current mode, the charge current value is known. Since the first output power value during the first charging is a predetermined value, when the charge characteristic information of the storage battery is present in which the charge current and the battery capacity in the constant voltage mode are associated with each other and the charge voltage and the battery capacity in the constant current mode are associated with each other, in the case of the constant voltage mode, the charge current value can be calculated from the first output voltage value and the charge voltage value, and the battery capacity can be estimated from the charge current value and the charge characteristic information. In the case of the constant current mode, the charge voltage value can be calculated from the first output power value and the charge current value, and the battery capacity can be estimated from the charge voltage value and the charge characteristic information. As described above, even when the information on the battery capacity cannot be acquired from the storage battery side, the battery capacity of the storage battery can be estimated.

Further, the present invention can also be configured as a charge schedule generation device that generates a charge schedule for charging a storage battery, the charge schedule generation unit including:
a second output power value acquisition unit configured to acquire a second output power value that is output to the storage battery in second charging in which the storage battery is charged over a predetermined time;
a mode determination unit configured to determine whether a charge mode for charging the storage battery is a constant voltage mode for holding a charge voltage at a predetermined voltage value or a constant current mode for holding a charge current at a predetermined current value on the basis of a direction of a change in the second output power value;
a characteristic information acquisition unit configured to associate the charge current with the battery capacity of the storage battery in the constant voltage mode, and acquire charge characteristic information of the storage battery in which the charge voltage and the battery capacity in the constant current mode are associated with each other;
a capacity estimation unit configured to output power of a predetermined second output power value to the storage battery over a predetermined time to perform first charging, configured to estimate the battery capacity on the basis of a charge current value, calculated from the first output power value and the predetermined voltage value, and the charge characteristic information when the constant voltage mode is determined, and configured to estimate the battery capacity on the basis of a charge voltage value, calculated from the first output power value and the predetermined current value, and the charge characteristic information when the constant current mode is determined;
a condition acquisition unit configured to acquire a condition related to a charge time for charging the storage battery and/or a condition including a target power to be a target during charging; and
a charge schedule generation unit configured to generate a charge schedule on the basis of the estimated battery capacity and the condition.

According to the above, the mode for charging the storage battery can be determined on the basis of the direction of the change in the second output power value during the second charging. When the mode for charging the storage battery is the constant voltage mode, the charge voltage value is known, and when the mode is the constant current mode, the charge current value is known. Since the second output power value during the first charging is a predetermined value, when the charge characteristic information of the storage battery is present in which the charge current and the battery capacity in the constant voltage mode are associated with each other and the charge voltage and the battery capacity in the constant current mode are associated with each other, in the case of the constant voltage mode, the charge current value can be calculated from the first output voltage value and the charge voltage value, and the battery capacity can be estimated from the charge current value and the charge characteristic information. In the case of the constant current mode, the charge voltage value can be calculated from the first output power value and the charge current value, and the battery capacity can be estimated from the charge voltage value and the charge characteristic information. By generating a charge schedule for the storage battery on the basis of conditions including the battery capacity and the chargeable time estimated in this manner, it is possible to generate an appropriate charge schedule even when information on the battery capacity cannot be acquired from the storage battery side.

Further, the present invention relates to a battery capacity estimation method for estimating battery capacity of a storage battery, the battery capacity estimation method including:
a second charge step of charging the storage battery over a predetermined time;
a step of determining a direction of a change in a second output power value that is output to the storage battery in the second charge step;
a step of determining whether the charge mode for charging the storage battery is a constant voltage mode for holding the charge voltage at a predetermined voltage value or a constant current mode for holding the charge current at a predetermined current value on the basis of the determination result of the direction of the change in the second output power value;
a step of acquiring charge characteristic information of the storage battery in which the charge current and the battery capacity in the constant voltage mode are associated with each other and the charge voltage and the battery capacity in the constant current mode are associated with each other;
a first charge step of outputting power of a first output power value to the storage battery over a predetermined time;
a step of estimating the battery capacity on the basis of a charge current value calculated from the first output power value and the predetermined voltage value and the charge characteristic information when the constant voltage mode is determined; and
a step of estimating the battery capacity on the basis of a charge voltage value, calculated from the first output power value and the predetermined current value, and the charge characteristic information when the constant current mode is determined.

According to the above, the second charging can be performed to charge the storage battery over a predetermined time, thereby determining the mode for charging the storage battery on the basis of the direction of the change in the second output power value during the second charging. When the mode for charging the storage battery is the constant voltage mode, the charge voltage value is known, and when the mode is the constant current mode, the charge current value is known. Since the first output power value during the first charging is a predetermined value, by acquiring the charge characteristic information of the storage battery in which the charge current and the battery capacity in the constant voltage mode are associated with each other and the charge voltage and the battery capacity in the constant current mode are associated with each other, in the case of the constant voltage mode, the charge current value can be calculated from the first output power value and the charge voltage value, and the battery capacity can be estimated from the charge current value and the charge characteristic information. In the case of the constant current mode, the charge voltage value can be calculated from the first output power value and the charge current value, and the battery capacity can be estimated from the charge voltage value and the charge characteristic information. As described above, even when the information on the battery capacity cannot be acquired from the storage battery side, the battery capacity of the storage battery can be estimated.

### EFFECT OF THE INVENTION

According to the present invention, it is possible to provide a technique capable of estimating the battery capacity of a storage battery even when information on the battery capacity cannot be acquired from the storage battery side.

### BRIEF DESCRIPTION OF THE DRAWINGS

Fig. 1 is a diagram illustrating a schematic configuration of a charge control system according to a first embodiment of the present invention.
Fig. 2 is a diagram for explaining a schematic configuration of an EV according to the first embodiment of the present invention.
Fig. 3 is a flowchart for explaining a procedure for a remaining level estimation process according to the first embodiment of the present invention.
Fig. 4 is a diagram for explaining a principle for charge mode determination according to the first embodiment of the present invention.
Fig. 5 is a diagram for explaining a principle for estimation of a remaining battery level according to the first embodiment of the present invention.
Fig. 6 is a flowchart for explaining procedures for a charge schedule generation process and a charge implementation process according to the first embodiment of the present invention.
Fig. 7 is a diagram illustrating an example of input conditions according to the first embodiment of the present invention.
Fig. 8 is a diagram illustrating a process for generating the charge schedule according to the first embodiment of the present invention.
Figs. 9A and 9B are diagrams illustrating charge control without a schedule as a comparative example.
Figs. 10A and 10B are diagrams illustrating a charge schedule according to the first embodiment of the present invention.
Figs. 11A and 11B are diagrams illustrating another charge schedule according to the first embodiment of the present invention and a comparative example.
Fig. 12 is a diagram illustrating a schematic configuration of a charge/discharge control system according to a second embodiment of the present invention.
Fig. 13 is a diagram illustrating a schematic configuration of an EV according to the second embodiment of the present invention.
Fig. 14 is a flowchart for explaining a procedure for a remaining level estimation process according to the second embodiment of the present invention.
Fig. 15 is a diagram for explaining a principle for remaining level estimation and mode determination according to the second embodiment of the present invention.
Fig. 16 is a diagram for explaining another principle for the remaining level estimation according to the second embodiment of the present invention.
Fig. 17 is a flowchart for explaining procedures for a discharge schedule generation process and a discharge implementation process according to the second embodiment of the present invention.

### MODE FOR CARRYING OUT THE INVENTION

### [Application Example]

Hereinafter, application examples of the present invention will be described with reference to the drawings.

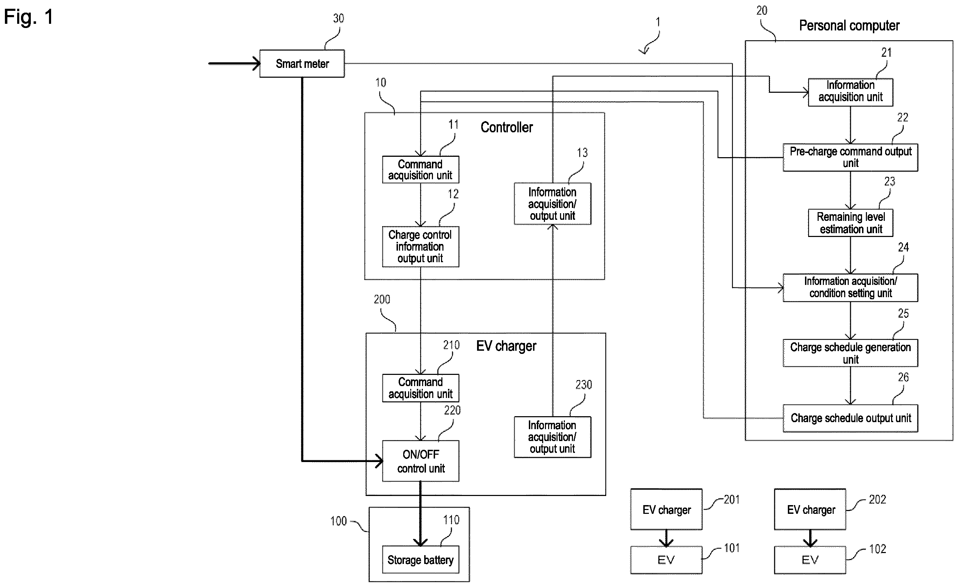

Fig. 1 illustrates a charge control system 1 according to an application example of the present invention.

The charge control system 1 includes: an electric vehicle (EV) charger 200 or the like for charging a storage battery 110 or the like, mounted in the electric vehicle (EV) 100 or the like, which is a mobile body; a controller 10 that manages the EV charger 200 or the like; a personal computer 20 that performs various processes in cooperation with the controller 10; and a smart meter 30.

The personal computer 20 includes an information acquisition unit 21, a pre-charge command output unit 22, a remaining level estimation unit 23, an information acquisition/condition setting unit 24, a charge schedule generation unit 25, and a charge schedule output unit 26. The controller 10 includes a command acquisition unit 11, a charge control information output unit 12, and an information acquisition/output unit 13. The EV charger 200 includes a command acquisition unit 210, an ON/OFF control unit 220, and an information acquisition/output unit 230 (the other EV chargers 201, 202 have the same configuration, but the description thereof will be omitted below).

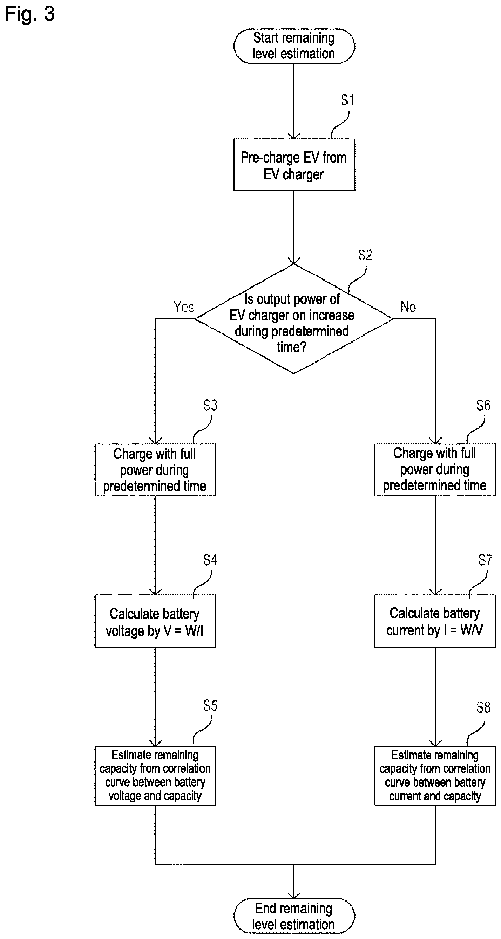

Fig. 3 illustrates a procedure for a remaining level estimation process for the storage battery 110 in the charge control system 1. The same applies to storage batteries mounted in the other EVs 101, 102, and hence only the storage battery 110 mounted in the EV 100 will be described below. The remaining battery level estimation process includes two phases: a charge mode determination process to determine whether the storage battery 110 connected to the EV charger 200 is being charged in a constant current (CC) mode or a constant voltage (CV) mode; and a remaining battery level estimation process in the determined CC mode or CV mode. In the following description, the amount of power stored in the storage battery in a certain state is referred to as a battery capacity or a remaining battery level (simply a remaining level). Here, the CC mode and the CV mode correspond to the first charge mode and the second charge mode of the present invention, respectively.

First, the EV charger 200 performs pre-charging on the storage battery 110 mounted in the EV 100 (step S1). Then, it is determined whether the output power of the EV charger 200 is on the increase or decrease during a predetermined time (step S2). Here, when the output power of the EV charger 200 is on the increase during the predetermined time, it is determined that the mode is the CC mode, and when the output power is on the decrease during the predetermined time, it is determined that the mode is the CV mode.

When it is determined that the charge control for the storage battery 110 is the CC mode, the full power is supplied to the EV over a predetermined time to charge the storage battery 110 (step S3). Although the full power is output in step S3, the power output from an on-board charger 130 and stored in the storage battery 110 becomes a predetermined output power value according to a command of a battery management system (BMS) mounted in the EV 100. The power value output from the EV charger 200 is also limited to the predetermined power value output from the on-board charger 130. Thus, the power stored in a storage battery 100, that is, the power value output from the on-board charger 130, is known as the actual output power value of the EV charger 200 that has received the full power output command from the controller 10, and the current is also known since charging is being performed in the CC mode. Therefore, assuming that the power with which the storage battery 110 is charged is W and the battery current is I, since W and I are known, the battery voltage V is calculated by V = W/I (step S4). Then, the remaining capacity of the storage battery 110 is estimated from the correlation curve between the battery voltage and the capacity (step S5), and the process ends.

When it is determined that the charge control for the storage battery 110 is in the CV mode, the full power is supplied to the EV 100 over a predetermined time to charge the storage battery 110 (step S6). In step S6, the full power, which is the rated power, of the EV charger 200 is output, the power output from an on-board charger 130 and stored in the storage battery 110 becomes a predetermined output power value according to a charge command of a battery management system (BMS) mounted in the EV 100. The power output from the EV charger 200 is also limited to a predetermined output power value. Thus, the power stored in the storage battery 100, that is, the power value output from the on-board charger 130, is known as the actual output power value of the EV charger 200 that has received the full power output command from the controller 10, and the voltage is also known since the charging is being performed in the CV mode. Therefore, assuming that the power with which the storage battery 110 is charged is W and the battery voltage is V, since W and V are known, the battery current I is calculated by V = W/V (step S7). Then, the remaining capacity of the storage battery 110 is estimated from the correlation curve between the battery current and the capacity (step S8), and the process ends.

With such a remaining level estimation process for the storage battery 110, the charge control system 1 can estimate the remaining battery level even when the battery information cannot be acquired from the EV 100 side.

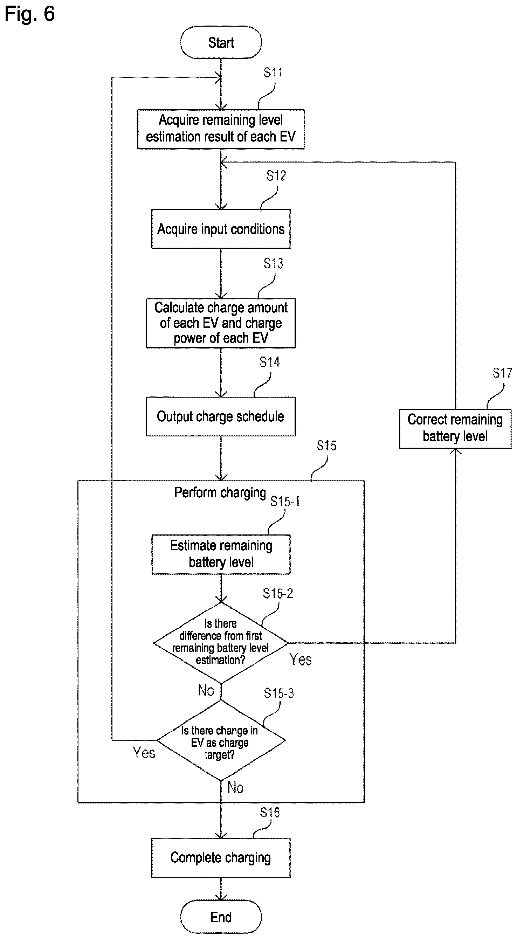

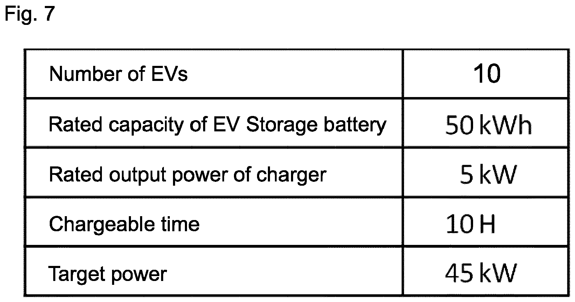

Fig. 6 illustrates procedures for a charge schedule generation process and a charge control performed by the charge control system 1. The remaining capacity of the storage battery 110 estimated as described above (step S11) and input conditions as illustrated in Fig. 7 (step S12) are acquired. The personal computer 20 calculates the charge amount and the charge power of the storage battery 110 or the like mounted in each EV or the like, generates a charge schedule including the charge power and the charge time calculated in this manner (step S13), and outputs the charge schedule to the controller 10 (step S14). The controller 10 outputs a command according to the charge schedule to the EV charger 200, and the EV charger 200 charges the storage battery 110 on the basis of the charge schedule (Steps S15 and S16). Further, the remaining battery level estimation is performed during charging (step S15-1), and when there is a difference from the first remaining battery level estimation (step S15-2), the charge schedule is corrected by the corrected remaining battery level (step S17).

In the generation of the charge schedule, the charge power and the charge time are calculated to satisfy conditions such as that the total value of the power used for charging is equal to or less than the target power when the plurality of EVs 100 or the like are charged simultaneously, and that the life of the battery is considered (specifically, it is desirable to charge the battery as slowly as possible and it is desirable that the idle time when the battery is fully charged be short).

In this way, even when the battery information cannot be acquired from the EV 100 side, the remaining battery level can be estimated, and an appropriate charge schedule that satisfies various conditions related to the electricity rate, the degradation of the battery, and the like can be generated on the basis of the estimated remaining battery level.

### [First Embodiment]

Hereinafter, the embodiments of the present invention will be described with reference to the drawings. However, the configuration of the device and the system described in each of the embodiments should be appropriately changed according to various conditions. That is, the scope of the present invention is not intended to be limited to the following embodiments.

Fig. 1 illustrates a schematic configuration of a charge control system 1 according to a first embodiment. The charge control system 1 includes: the EV charger (external charger or first charger) 200 for charging the storage battery 110 mounted in the EV 100; the EVs 101, 102 (the storage batteries mounted therein in the same manner are omitted); the EV chargers 201, 202; the controller 10 that manages the EV charger 200 or the like; the personal computer 20 that performs various processes in cooperation with the controller 10; and the smart meter 30. In Fig. 1, the thick line indicates the flow of electric power (the flows of power from the smart meter 30 to the EV chargers 201, 202 are omitted), and the thin line indicates the flow of information. In Fig. 1, three EV chargers 200, 201, 202 are connected to the controller 10, and the EVs 100, 101, 102 are connected to the respective EV chargers. However, the number of EV chargers connected to the controller 10 and the number of EVs are not limited thereto.

Here, the storage battery 110 mounted in the EV 100 will be described, but the storage battery may be a stationary storage battery. The type of the storage battery is not particularly limited, and for example, a lithium-ion battery, an all-solid-state battery, a nickel cadmium battery, a nickel hydrogen battery, a lead storage battery, and the like can be adopted. In addition, the battery is not limited to those in EVs, and may be a storage battery mounted in a mobile body such as an electric motorcycle, an electric bicycle, or a drone using a storage battery as a power source.

By connecting the EVs 100 or the like to the plurality of EV chargers 200 or the like, the storage batteries 110 or the like mounted in the plurality of EVs can be charged. The EV charger 200 includes the command acquisition unit 210, the ON/OFF control unit 220, and the information acquisition/output unit 230. Power supplied from a commercial power system is input to each EV charger 200 or the like via the smart meter 30 (although only the EV charger is illustrated in the figure, power is similarly input to the other EV chargers via the smart meter 30). In addition, the command acquisition unit 210 of the EV charger 200 acquires a charge command from the controller 10, and outputs the command to the ON/OFF control unit 220. The ON/OFF control unit 220 of the EV charger 200 controls the ON/OFF switch on the basis of the charge command to supply the electric power input to the EV charger 200 to the EV 100 or stop the supply, thus charging the storage battery 110 mounted in the EV 100. The information acquisition/output unit 230 acquires the information of the output power to the EV 100, and outputs the information to an information acquisition/output unit 13 of the controller 10, which will be described later. The smart meter 30 measures the power consumption of the connected EV charger 200 and outputs the power consumption information to the personal computer 20. The controller 10 may acquire the power consumption information through the communication with the EV charger 200 or the like and output the power consumption information to the personal computer 20.

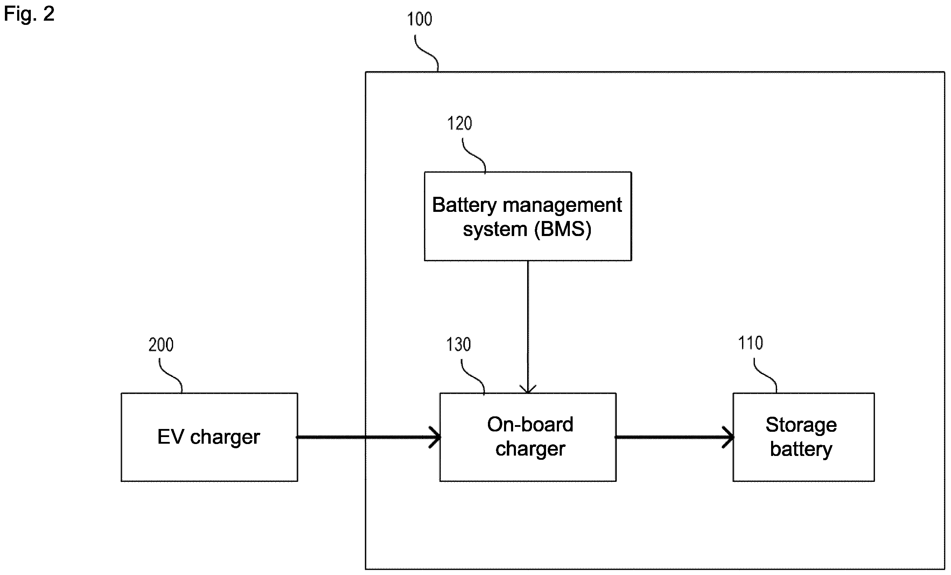

Fig. 2 is a diagram illustrating the EV charger 200 and the EV 100 taken out of Fig. 1. The same applies to the EV charger 201 and the EV 101, and the EV charger 202 and the EV 102, and hence the description thereof will be omitted. In Fig. 2 as well, the thick line indicates the flow of power, and the thin line indicates the flow of information.

As illustrated in Fig. 2, the EV 100 includes a battery management system (BMS) 120 and an on-board charger (on-vehicle charger or second charger) 130 as a configuration related to the charging of the storage battery 110. The power supplied from the EV charger 200 is input to the on-board charger 130 of the EV 100. The BMS 120 grasps the capacity information and the like of the storage battery 110, determines a charge mode such as a CC mode or a CV mode on the basis of the capacity information and the like, and outputs a charge command in the CC mode, the CV mode, or the like to the on-board charger 130. The on-board charger 130 receives the charge command from the BMS 120 and charges the storage battery 110 according to the received charge command. At this time, the on-board charger 130 converts AC power supplied from the EV charger 200 into DC power and outputs the DC power to the storage battery 110. As described above, the power output from the on-board charger 130 to charge the storage battery 110 becomes a predetermined power value according to the charge command of the BMS. Therefore, as described later, even when the full power is output from the EV charger 200, the on-board charger 130 that receives the power supplied from the EV charger 200 outputs the predetermined power value to the storage battery 110 according to the charge command of the BMS. Thus, the power actually output from the EV charger 200 is also limited to the power output from the on-board charger 130, and becomes the predetermined power value.

In the charge control system 1, the controller 10, which manages each EV charger 200 or the like, and the personal computer 20 perform various processes in cooperation with each other. The personal computer 20 and the controller 10 are communicably connected by a wired or wireless network. As a communication method between the personal computer 20 and the controller 10, for example, Ethernet (registered trademark) can be adopted, but the communication method is not limited thereto. Various functions realized in the personal computer 20 as described below may be realized in the controller 10, and the division of functions between the personal computer 20 and the controller 10 is not limited to the example described below. Here, the personal computer 20 corresponds to the battery capacity estimation device and the charge schedule generation device of the present invention. However, the battery capacity estimation device and the charge schedule generation device of the present invention may be configured by the personal computer 20 and the controller 10.

The personal computer 20 includes the information acquisition unit 21, the pre-charge command output unit 22, the remaining level estimation unit 23, an information acquisition/condition setting unit 24, the charge schedule generation unit 25, and the charge schedule output unit 26. The personal computer 20 is a computer including a processor such as a central processing unit (CPU) or a graphic processing unit (GPU), a main storage device such as a random-access memory (RAM) or a read-only memory (ROM), and an auxiliary storage device such as an erasable programmable read-only memory (EPROM), a hard disk drive, or a removable medium. Note that the removable medium may be, for example, a universal serial bus (USB) memory or a disk recording medium such as a compact disc (CD) or a digital versatile disc (DVD). An operating system (OS), various programs, various tables, and the like are stored in the auxiliary storage device, and the programs stored therein are loaded into a work area of the main storage device and executed. Each component and the like are then controlled through the execution of the programs, whereby each function meeting a predetermined purpose as described later can be realized. However, some or all of the functions may be realized by a hardware circuit such as an application-specific integrated circuit (ASIC) or a field-programmable gate array (FPGA). Note that the personal computer 20 may be a single personal computer or a plurality of personal computers that cooperate with each other.

The information acquisition unit 21 acquires, from the information acquisition/output unit 13 of the controller 10, information such as whether the EV 100 or the like are connected to each EV charger 200 or the like, and the output power from each EV charger 200 or the like to the EV 100 or the like. The pre-charge command output unit 22 outputs a charge time and a charge power command for estimating a remaining level to the controller 10. The remaining level estimation unit 23 estimates the remaining battery level from the output power information from the EV charger 200 and the battery charge characteristics of the storage battery 110 mounted in the EV 100. The information acquisition/condition setting unit 24 acquires the estimated remaining battery level information and the power consumption information from the smart meter, and sets conditions such as the target power, the rated output of the EV charger 200, and a predetermined number of vehicles. The charge schedule generation unit 25 calculates the charge power and the charge time of each EV 100 or the like from the acquired information and the set conditions, and creates a charge schedule or corrects the created charge schedule. The charge schedule output unit 26 outputs the charge schedule to the controller 10. The target power is power targeted for reducing the maximum power when the charge schedule is generated.

The controller 10 includes a command acquisition unit 11, a charge control information output unit 12, and an information acquisition/output unit 13. The command acquisition unit 11 acquires a pre-charge command from the pre-charge command output unit 22 of the personal computer 20, and acquires a charge schedule from the charge schedule output unit 26. The charge control information output unit 12 outputs charge control information such as charge time and charge power to the EV charger 200. The information acquisition/output unit 13 acquires information such as output power from the EV charger 200 and outputs the information to the personal computer 20. As a communication method between the controller 10 and each EV charger 200 or the like, for example, ECHONET Lite can be adopted, but the communication method is not limited thereto.

### (Remaining battery level estimation method)

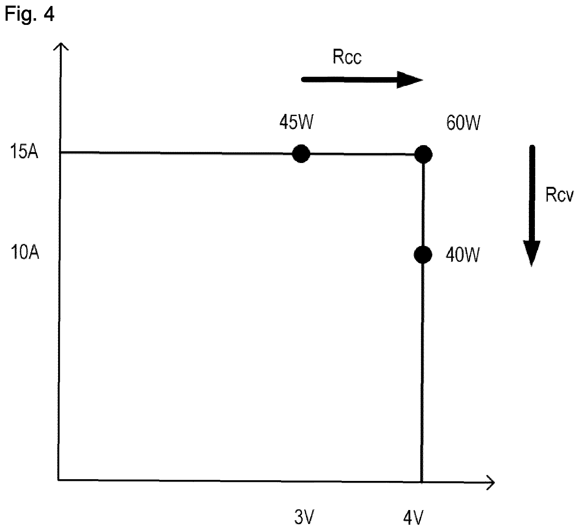

Hereinafter, a remaining battery level estimation method executed by the personal computer 20 and the controller 10 will be described. Fig. 3 is a flowchart for explaining a process procedure for estimating a remaining battery level, and Fig. 4 is a diagram for explaining a principle for charge mode determination. Here, the remaining battery level estimation method corresponds to the battery capacity estimation method of the present invention.

The remaining battery level estimation process roughly includes two phases. That is, the charge control of the storage battery 110 connected to the EV charger 200 includes two phases: a charge mode determination process (first phase) of determining whether the charge control is being performed in a constant current (CC) mode of holding the charge current at a predetermined current value or a constant voltage (CV) mode of holding the charge voltage at a predetermined voltage value; and a remaining battery level estimation process (second phase) in the determined CC mode or CV mode. As the remaining battery level estimation process, the first phase and the second phase may be executed, or the first phase may be omitted, and only the remaining battery level estimation process in the CC mode of the second phase, or the remaining battery level estimation process in the CC mode or the remaining battery level estimation process in the CV mode may be executed. When the charge mode determination process is not executed, instead, it may be determined which mode is used to obtain the capacity estimation result or which mode is used to execute the remaining battery level estimation process on the basis of the driving distance, the use time, and the like of the EV 100 or the like.

For example, the information acquisition unit 21 of the personal computer 20 starts the remaining battery level estimation process with the acquisition of the information indicating that the EV 100 or the like has been connected to any EV charger 200 or the like from the controller 10 as a trigger.

First, the pre-charge command output unit 22 outputs a first-phase pre-charge command (first pre-charge command) to the controller 10. The first pre-charge command includes a command related to charge time and charge power. In the controller 10, the command acquisition unit 11 acquires the first pre-charge command, and the charge control information output unit 12 outputs the first pre-charge control command for the first-phase pre-charging to the EV charger 200. In the EV charger 200, the command acquisition unit 210 acquires the first pre-charge control command, and the ON/OFF control unit 220 controls the ON/OFF switch to supply predetermined power to the EV 100 over a predetermined time according to the first pre-charge control command including information on the charge time and the charge power, thereby pre-charging the storage battery 110 (step S1). Here, the first-phase pre-charging corresponds to the second charging and the second charge step of the present invention.

Next, the EV charger 200 acquires the output power value of the EV charger 200 during a predetermined time, and outputs the output power value from the information acquisition/output unit 230 to the controller 10. The controller 10 outputs the above-described information described above, acquired by the information acquisition/output unit 13, to the personal computer 20. The remaining level estimation unit 23 of the personal computer 20 determines whether the output power value of the EV charger 200 acquired by the information acquisition unit 21 is on the increase or decrease, that is, whether the charge mode for the storage battery is the CC mode or the CV mode (step S2). That is, when the output power value of the EV charger 200 is on the increase during the predetermined time, it is determined that the mode is the CC mode, and when the output power value is on the decrease during the predetermined time, it is determined that the mode is the CV mode. The output power value of the EV charger 200 in the first-phase pre-charging corresponds to the second output power value of the present invention. The information acquisition unit 21 and the remaining level estimation unit 23 of the personal computer 20 correspond to the second output power value acquisition unit and the mode determination unit of the present invention, respectively. Step S2 corresponds to the mode determination step of the present invention.

### (Principle for charge mode determination)

As illustrated in Fig. 4, when the charge mode for the storage battery 110 is the CC mode, the current is constant, and the voltage changes so as to increase. Therefore, for example, a constant current of 15 A is output, and the output voltage increases from 3 V to 4 V with the progress of charging as indicated by an arrow Rcc. Here, the output power is 45 W when the current is 15 A and the voltage is 3 V, and the output power is 60 W when the current is 15 A and the voltage is 4 V, thus leading to an increase in output power from 45 W to 60 W. Accordingly, when the output power of the EV charger 200 is on the increase during the predetermined time, it is determined that the mode is the CC mode. When the charge mode for the storage battery 110 is the CV mode, the voltage is constant, and the current changes so as to decrease. Therefore, for example, a constant voltage of 4 V is output, and the output current decreases from 15 A to 10 A with the progress of charging as indicated by an arrow Rcv. Here, the output power is 60 W when the voltage is 4 V and the current is 15 A, and the output power is 40 W when the voltage is 4 V and the current is 10 A, thus leading to a decrease in output power from 60 W to 40 W. Accordingly, when the output power of the EV charger 200 is on the decrease during the predetermined time, it is determined that the mode is the CV mode.

As described above, the charge mode determination process, which is the first phase, includes steps S1 and S2. Then, according to the determination result in step S2, the process proceeds to the remaining battery level estimation process, which is the second phase.

When it is determined in step S2 that the output power of the EV charger 200 is on the increase during the predetermined time, that is, when it is determined that the charge control for the storage battery 110 is in the CC mode, the process proceeds to step S3. At this time, the pre-charge command output unit 22 outputs a second-phase pre-charge command (second pre-charge command) to the controller 10. The second pre-charge command includes a command related to charge time and charge power (here, the full power, which is the rated output of the EV charger 200). In the controller 10, the command acquisition unit 11 acquires the second pre-charge command, and the charge control information output unit 12 outputs the second pre-charge control command for the second-phase pre-charging to the EV charger 200. In the EV charger 200, the command acquisition unit 210 acquires the second pre-charge control command, and the ON/OFF control unit 220 controls the ON/OFF switch to supply the full power to the EV 100 over a predetermined time according to the second pre-charge control command including information on the charge time and the charge power to charge the storage battery 110 (step S3). Here, the second-phase pre-charging corresponds to the first charging and the first charge step of the present invention.

In step S3, the full power, which is the rated power, of the EV charger 200 is output to the storage battery 110, but the power actually output from the on-board charger 130 and charged in the storage battery 110 becomes a predetermined output power value according to the charge command of the BMS. Since the power output from the EV charger 200 is also limited to this predetermined output power value, the power stored in the storage battery 110 is known as the actual output power value of the EV charger 200 that has received the full power output command from the controller 10. In addition, the charge current is also known since charging is being performed in the CC mode. Therefore, assuming that the power with which the storage battery 110 is charged is W and the charge current is I, since W and I are known, the remaining level estimation unit 23 calculates the charge voltage V by V = W/I (step S4). Here, W, I, and V correspond to the first output power value, the predetermined current value, and the charge voltage value of the present invention, respectively.

Then, the remaining level estimation unit 23 estimates the remaining capacity of the storage battery 110 from the correlation curve between the charge voltage and the capacity (step S5), and ends the process. The remaining capacity estimation of the storage battery 110 will be described later together with the case where the CV mode is determined. Here, the processes from step S3 to step S5 correspond to the first estimation process, the first estimation process step, and the capacity estimation step of the present invention. Here, although the charge voltage V is calculated in step S4, the charge power can be calculated when the charge current and the charge voltage are known. Therefore, when correlation curves between the charge current/charge power and the capacity or a table associating these is acquired in advance as the charge characteristic information on the basis of the correlation curves between the charge current/charge power and the capacity, step S4 of calculating the charge voltage can be omitted, and the estimation of the remaining capacity in step S5 can be performed (the same applies to steps S7 and S8 in the CV mode).

When it is determined in step S2 that the output power of the EV charger 200 is on the decrease during the predetermined time, that is, when it is determined that the charge control for the storage battery 110 is in the CV mode, the process proceeds to step S6. At this time, the pre-charge command output unit 22 outputs a second-phase pre-charge command (second pre-charge command) to the controller 10. The second pre-charge command includes a command related to charge time and charge power (here, the full power, which is the rated output of the EV charger 200). In the controller 10, the command acquisition unit 11 acquires the second pre-charge command, and the charge control information output unit 12 outputs the second pre-charge control command for the second-phase pre-charging to the EV charger 200. In the EV charger 200, the command acquisition unit 210 acquires the second pre-charge control command, and the ON/OFF control unit 220 controls the ON/OFF switch to supply the full power to the EV 100 over a predetermined time according to the second pre-charge control command including information on the charge time and the charge power, thereby charging the storage battery 110 (step S6).

In step S6, the full power, which is the rated power, of the EV charger 200 is output to the storage battery 110, but the power actually output from the on-board charger 130 and charged in the storage battery 110 becomes a predetermined output power value according to the charge command of the BMS. Since the power output from the EV charger 200 is also limited to this predetermined output power value, the power stored in the storage battery 110 is known as the actual output power value of the EV charger 200 that has received the full power output command from the controller 10. In addition, the voltage is also known since the storage battery 110 is charged in the CV mode. Therefore, assuming that the power with which the storage battery 110 is charged is W and the charge voltage is V, since W and V are known, the remaining level estimation unit 23 calculates the battery current I by V = W/V (step S7). Here, W, V, and I correspond to the first output power value, the predetermined voltage value, and the charge current value of the present invention, respectively.

Then, the remaining level estimation unit 23 estimates the remaining capacity of the storage battery 110 from the correlation curve between the charge current and the capacity (step S8), and ends the process. Here, the processes from step S6 to step S8 correspond to the second estimation process, the second estimation process step, and the capacity estimation step of the present invention. In the flowchart illustrated in Fig. 3, the first-phase pre-charging (step S1) and the second-phase pre-charging (steps S3 and S6) are separately described, but pre-charging for a predetermined time (e.g., about 1 minute) may also serve as the first-phase pre-charging and the second-phase pre-charging. When the first-phase pre-charging and the second-phase pre-charging are performed as a single process as described above, the first charging and the second charging of the present invention correspond to the same charging.

### (Principle for remaining battery level estimation)

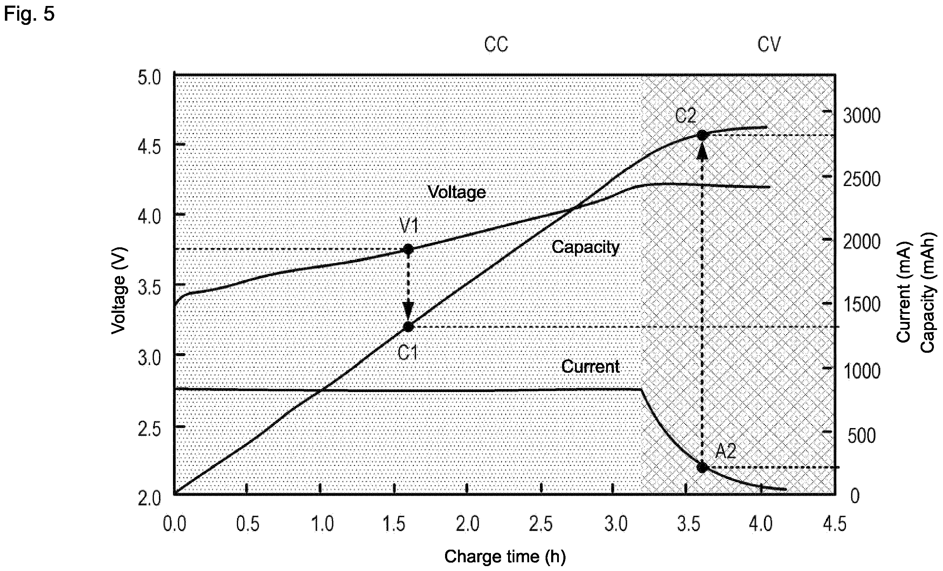

The principle for the remaining battery level estimation in each mode will be described with reference to Fig. 5. Fig. 5 is a charge characteristic graph illustrating changes in capacity, voltage, and current when constant voltage/constant current charging is performed on the storage battery 110, with the charge time (h) on the horizontal axis and the voltage (V), current (mA), and capacity (mAh) on the vertical axis. A range indicated by a dot hatching pattern on the left side of Fig. 5 represents charging in the CC mode, and a range indicated by a lattice hatching pattern on the right side of Fig. 5 represents charging in the CV mode. In the charging in the CC mode, the charge current is constant, and the charge voltage increases as the charging progresses and the battery capacity increases. In the charging in the CV mode, the charge voltage is constant, and the charge current decreases as the charging progresses and the battery capacity increases. The battery capacity increases at a substantially constant slope with the progress of charging, and then the slope becomes gentle. Here, the charge characteristic graph corresponds to the charge characteristic information of the present invention, the charge characteristic graph including the range indicated by the dot hatching pattern on the left side of the charge characteristic graph corresponds to the first charge characteristic information of the present invention, and the charge characteristic graph including the range indicated by the grid hatching pattern on the right side of the charge characteristic graph corresponds to the second charge characteristic information.

When it is determined in step S2 that the charge mode is the CC mode, and the voltage calculated from the power and the current in step S4 is 3.75 V, it can be seen that the charge state is as indicated by point V1 on the curve representing the change in the charge voltage of the storage battery 110. The battery capacity in such a charged state is represented by point C1, and the battery capacity is estimated to be 1300 mAh. As described above, since the charge voltage and the battery capacity calculated in step S4 have a correlation, a correlation curve, which is information indicating a correlation between the charge voltage and the battery capacity, is held in a predetermined storage area. Thereby, in step S5, the remaining level estimation unit 23 can estimate the remaining capacity from the calculated charge voltage and the correlation curve between the read charge voltage and the battery capacity. The correlation curve may be held in advance in a predetermined storage area as described above, may be input from an input unit such as a keyboard or a touch panel, or may be acquired from an external server via a network. The correlation curve between the charge voltage and the battery capacity is included in the first charge characteristic information of the present invention. Reading the charge characteristic graph including the correlation curve between the charge voltage and the battery capacity from a predetermined storage area, receiving an input from the input unit, or acquiring the charge characteristic graph via the network corresponds to the charge characteristic information acquisition step of the present invention.

When it is determined in step S2 that the charge mode is the CV mode and the current calculated in step S7 is 200 mA, it can be seen that the charge state is as indicated by point A2 on the curve representing the change in the charge current of the storage battery 110. The battery capacity in such a charged state is represented by C2, and the battery capacity is estimated to be 2800 mAh. As described above, since the charge current and the battery capacity calculated in step S7 have a correlation, a correlation curve, which is information indicating a correlation between the charge current and the battery capacity, is held in a predetermined storage area. Thereby, in step S8, the remaining level estimation unit 23 can estimate the remaining capacity from the calculated charge current and the correlation curve between the read charge current and the battery capacity. The correlation curve may be held in advance in a predetermined storage area as described above, may be input from the input unit such as the keyboard or the touch panel, or may be acquired from an external server via the network. The correlation curve between the charge current and the battery capacity is included in the second charge characteristic information of the present invention. Reading the charge characteristic graph including the correlation curve between the charge current and the battery voltage from a predetermined storage area, receiving an input from the input unit, or acquiring the charge characteristic graph via the network corresponds to the charge characteristic information acquisition step of the present invention.

By estimating the remaining battery level in this manner, the remaining battery level can be estimated even when the battery information cannot be acquired from the EV 100 side.

### (Generation of charge schedule)

Hereinafter, a method for generating a charge schedule and a charge control method based on the generated charge schedule, both executed by the personal computer 20 and the controller 10, will be described.

Fig. 6 is a flowchart for explaining a process procedure for generating a charge schedule and a process procedure for performing charge control based on the generated charge schedule.

First, the information acquisition/condition setting unit 24 acquires the remaining level estimation result of the storage battery 110 mounted in each EV 100 or the like connected to the EV charger 200 (step S11).

Next, the information acquisition/condition setting unit 24 acquires input conditions (step S12). The input conditions are the number of EVs 100 or the like to be charged, the rated capacity of the storage battery 110 or the like mounted in the EV 100 or the like, the rated output power of the EV charger 200, the chargeable time, the target power, and the like. These pieces of information may be input from the input unit such as the keyboard or the touch panel, may be held in advance in a predetermined storage area, or may be acquired from an external server via the network. Fig. 7 illustrates a data configuration example acquired as input conditions. Here, as the input conditions, information is acquired that the number of EVs is 10, the rated capacity of a storage battery or the like mounted in the EV is 50 kW, the rated output power of the EV charger is 5 kW, the chargeable time is 10 hours (e.g., from 22:00 to 8:00 on the next day), and the target power is 45 kW. Here, the information acquisition/condition setting unit 24 corresponds to the condition acquisition unit of the present invention. Here, contract power is set as the target power, but the value that can be set as the target power is not limited thereto. For example, a power value obtained by subtracting, from the contract power, the power supplied to a load other than the EV 100 and the like or a predicted value obtained from an actual value of power consumption in the same time zone in the past may be used as the target value. In addition, a value obtained by subtracting a predetermined power value from the contract power, or a power value of a predetermined ratio of the contract power (e.g., 90% of the contract power), can be set as the target power value.

Next, the charge schedule generation unit 25 calculates the charge amount of the storage battery 110 or the like mounted in each EV 100 or the like and the charge power to the storage battery 110 or the like of each EV 100 or the like on the basis of the acquired input conditions and the acquired remaining level estimation result of the storage battery 110 or the like, and generates a charge schedule including these (step S13).

Constraint conditions are as follows when the charge power and the charge time of the storage battery 110 or the like mounted in each EV 100 or the like, which are control variables, are calculated on the basis of the remaining level estimation result of the storage battery 110 or the like and the input conditions: the total value of the power used for charging is equal to or less than the target power when the plurality of EVs 100 or the like are simultaneously charged; and the life of the battery is considered (specifically, it is desirable to charge the battery as slowly as possible and it is desirable that the idle time when the battery is fully charged be short). The objective function is that the storage batteries 110 or the like of all the EVs 100 or the like are fully charged by the operation start time of the next day.

The basic relational expression for each EV 100 or the like in the generation of the charge schedule is as follows:
- Charge amount = Rated capacity of storage battery - Remaining capacity of storage battery
- Charge power × Charge time = Charge amount. Here, the rated capacity of the storage battery is set according to the input conditions and is thus known, and the remaining capacity of the storage battery has been estimated by the remaining level estimation process and is thus known. Therefore, the charge amount is known, and the charge power and the charge time are variables as described above.

Further, the constraint condition is expressed as the following relational expression.
- Total charge power in the case of simultaneous charging of a plurality of EVs ≤ Target power
- Maximum charge power of one EV ≤ Target power/umber of EVs
- Charge time ≤ Chargeable time

Here, the target power, the number of EVs, and the chargeable time are set according to the input conditions and are thus known.

The charge schedule generation unit 25 calculates the charge power and the charge time, which satisfy the constraint conditions described above, for the storage battery 110 or the like mounted in each EV 100 or the like. In the above example, the charge schedule is generated on the basis of the contract power set as the target power, but the target value is not limited thereto. Therefore, when power is also supplied to a load other than the EV charger 200 and the like via the smart meter, the charge schedule may be generated on the basis of power obtained by subtracting the power, supplied to another load, from the contract power, or the charge schedule may be generated on the basis of power obtained by subtracting a predicted value, obtained from an actual value of power consumption in the same time zone in the past, from the contract power. A threshold obtained by subtracting a predetermined value from the value as described above may be determined, and a charge schedule may be generated on the basis of such a threshold. As the input conditions, the number of fully charged EVs, the charge capacity, and the like that are desired to be ensured at minimum in preparation for disaster may be set, and the charge schedule may be created on the basis of these conditions. Further, as the input conditions, the charge start time and the charge end time can be set, the charge start time and the charge end time may be set for each EV, and a charge schedule may be created on the basis of these conditions. Here, the chargeable time corresponds to the information regarding the charge time of the present invention, but the charge time is not limited thereto. The charge time includes, for example, the charge start time, the charge completion time, and the like of each EV or all EVs.

Then, the charge schedule output unit 26 outputs the charge schedule generated in this manner to the controller 10.

### (Example of charge schedule)

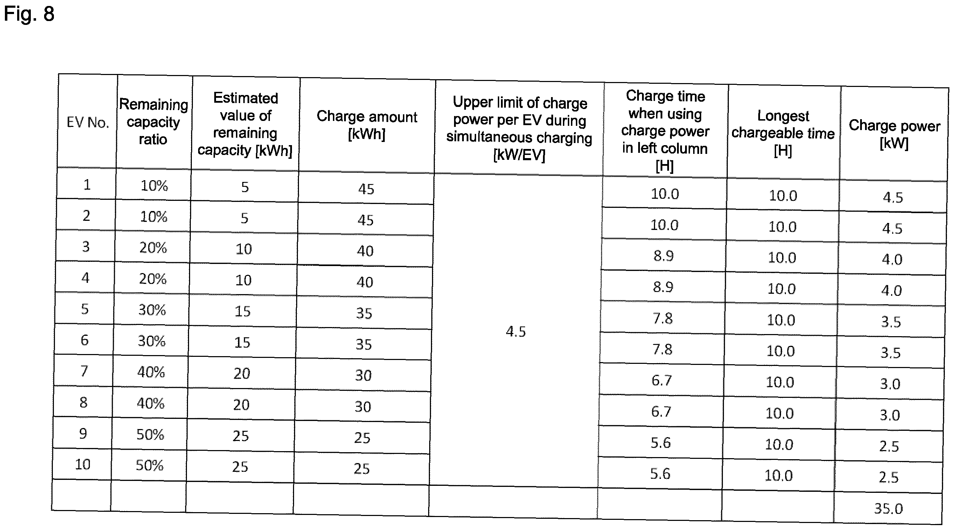

Fig. 8 illustrates an example of the charge schedule including the charge amount and the charge power for the storage battery 110 or the like of each EV 100 or the like calculated on the basis of the input conditions described above. In Fig. 8, ten EVs connected to the EV charger are identified with numbers 1 to 10. The estimated remaining capacity values (kWh) of the storage batteries mounted in the EVs from No. 1 to No. 10 are 5, 5, 10, 10, 15, 15, 20, 20, 25, and 25, respectively. The rated capacity of the storage battery or the like mounted in the EV is 50 kWh, and hence the remaining capacity ratios (%) of the storage batteries mounted in the EVs from No. 1 to No. 10 are 10, 10, 20, 20, 30, 30, 40, 40, 50, and 50, respectively. From the estimated remaining capacity values described above and the rated capacity (50 kWh) of the storage battery mounted in the EV battery, the charge amount (kWh) of the storage battery mounted in each of EVs from No. 1 to No. 10 is calculated as 45, 45, 40, 40, 35, 35, 30, 30, 25, and 25. Since the target power is 45 kW, the upper limit of the charge power per EV during simultaneous charging is calculated as 4.5 (kW/EV), and with this upper limit of the charge power, the charge time (H) when the storage batteries mounted in the EVs from No. 1 to No. 10 are charged is calculated as 10.0, 10.0, 8.9, 8.9, 7.8, 7.8, 6.7, 6.7, 5.6, and 5.6. According to the input conditions, the maximum chargeable time is 10 H, thus enabling the completion of charging within the chargeable time for any EV. To reduce the degradation of the storage battery, it is desirable to charge the storage battery as slowly as possible. Therefore, by dividing the charge amount of the storage battery mounted in each EV by the longest chargeable time, the charge power (kW) for charging the storage battery mounted in each of the EVs from No. 1 to No. 10 is calculated as 4.5, 4.5, 4.0, 4.0, 3.5, 3.5, 3.0, 3.0, 2.5, and 2.5, respectively. At this time, since the total value of the charge power is 35.0 kW, which is smaller than 45 kW of the contract power set as the target power, the electricity rate does not increase.

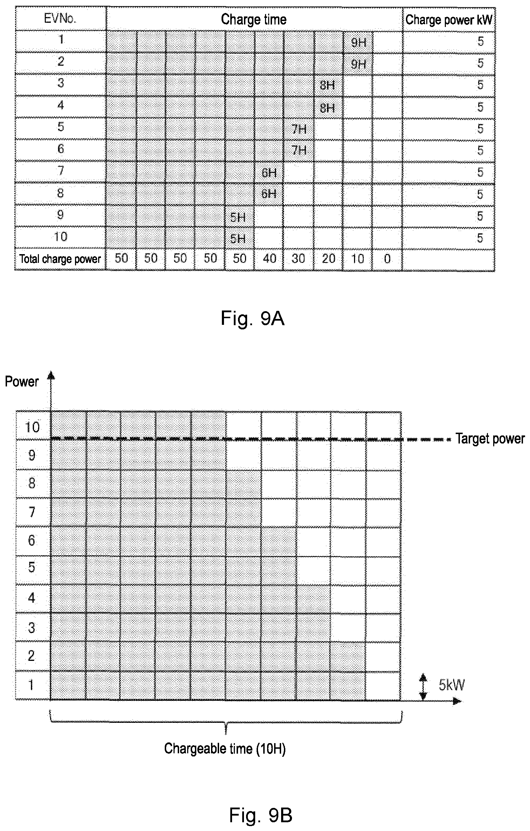

Fig. 9A illustrates a case where the storage battery mounted in each EV is charged without a schedule under the input conditions described above, for example, a case where the storage battery is charged at the rated output power of 5 kW of the EV charger. In Fig. 9A, a hatched portion represents the charge time of each EV, and one cell of the charge time represents 1 hour in the lateral direction. Here, the charge times (H) of the storage batteries mounted in the EVs from No. 1 to No. 10 are 9, 9, 8, 8, 7, 7, 6, 6, 5, and 5, respectively. In this case, for 5 hours from the start of charging, the total charge power is 50 kW exceeding 45 kW of the target power. Fig. 9B is a diagram illustrating the relationship between the charge power and the peak power of each EV by the charge control described above, and a hatched portion represents the charge time of each EV (however, the numbers specifying the EVs are arranged from bottom to top so that the numbers increase). The horizontal axis in Fig. 9B represents the charge time similarly to Fig. 9A, and one cell in the horizontal direction represents 1 hour. Then, the vertical axis of Fig. 9B represents power, and one cell in the vertical direction represents the magnitude of each EV charge power. Here, the charge power is the same 5 kW for all the EVs, so that the height of one cell for each EV is the same. From Fig. 9B, it can be seen that the target power exceeds 45 kW at 5 hours from the start of charging in charge control without a schedule described above.

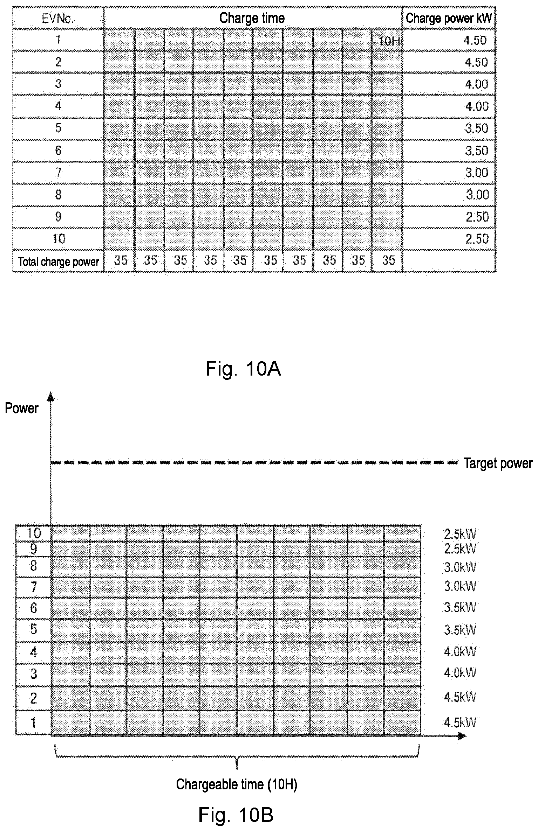

On the other hand, an example of the charge schedule generated and output as described above is illustrated in Fig. 10A. In Fig. 10A, a hatched portion is the charge time of each EV, and one cell of the charge time represents 1 hour in the lateral direction. As described above, since the charge power and the charge time are set for the storage battery mounted in each EV, the total value of the charge power over 10 hours from the start of charging to the completion of charging is 35 kW, which is 45 kW or less of the target power. In addition, since the storage battery mounted in each EV is charged in the longest chargeable time, charging is performed as slowly as possible, and the degradation of the storage battery can be reduced. Moreover, since the battery is charged so as to be fully charged immediately before the target time for completion of charging, the time when the storage battery is left in a fully charged state is short. Fig. 10B is a diagram illustrating the relationship between the charge power and the peak power of each EV by the charge control according to the charge schedule, and a hatched portion represents the charge time of each EV (however, the numbers specifying the EVs are arranged from bottom to top so that the numbers increase). The horizontal axis in Fig. 10B represents the charge time similarly to Fig. 10A, and one cell in the horizontal direction represents 1 hour. Then, the vertical axis of Fig. 10B represents power, and one cell in the vertical direction represents the magnitude of each EV charge power. Here, the height of one cell in the vertical direction varies depending on the charge power defined in the charge schedule for each EV. From Fig. 10B, it can be seen that in the charge control according to the charge schedule described above, the total value of the charge power is 35 kW, and is 45 kW or less of the target power in any time zone from the start to the completion of charging. Here, the target charge amount at which the charging of the storage battery is completed is set to the full charge, but the target charge amount is not limited thereto, and can be appropriately set to 80% of the full charge or the like in consideration of the life of the storage battery. As illustrated in Fig. 10A, the charge power is constant over the entire period of the chargeable time, but the charge schedule is not limited to such a schedule. For example, a charge schedule in which the charge power is changed within the chargeable period, such as increasing the charge power in the first half of the chargeable time and decreasing the charge power in the latter half of the chargeable period, is also possible. Further, when a plurality of EVs are connected, such a temporal change in the charge power may be made different for each EV. The target power of 45 kW corresponds to the upper limit value of the total charge power of the plurality of storage batteries in the present invention.

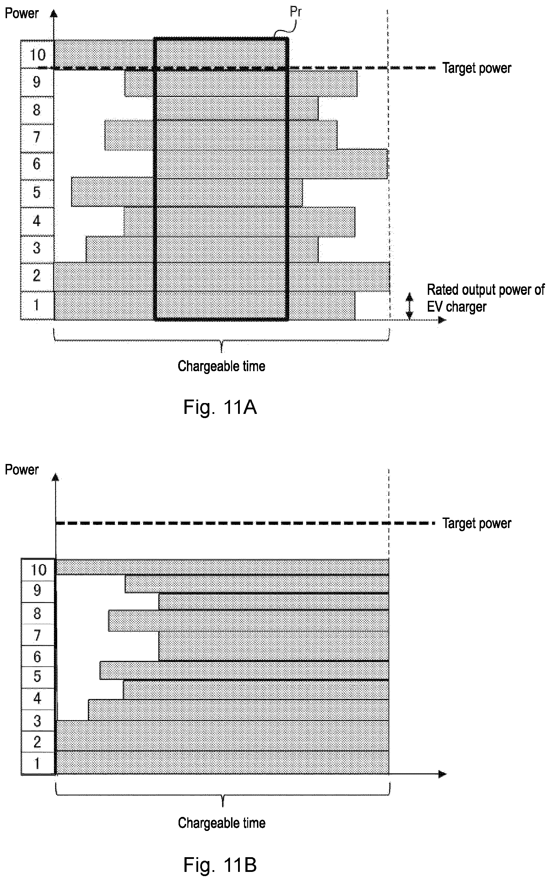

Figs. 11A and 11B are diagrams illustrating the relationship between the peak power and the target power in the charge control when no schedule is generated and when the charge schedule is generated, in a case where the return time (charging start possible time) of the EV and the operation start time (charging completion possible time) of the next day vary among the EVs. Fig. 11A illustrates a case where the storage battery mounted in each EV is charged at the rated output voltage of the EV charger, similarly to when no schedule is generated as described above. Here, in the time zone surrounded by a frame Pr, the total value of the charge power of the EVs exceeds the target power. On the other hand, as illustrated in Fig. 11B, when the charge schedule is generated, since the charge power and the chargeable time can be set, the charge time can be extended to reduce the charge power. Therefore, the total value of the charge power becomes equal to or less than the target power in any time zone of the chargeable time, and the charging can be completed without exceeding the target power. In addition, since the storage battery mounted in each EV is charged in the longest chargeable time, charging is performed as slowly as possible, and the degradation of the storage battery can be reduced. Moreover, since the battery is charged so as to be fully charged immediately before the target time for completion of charging, the time when the storage battery is left in a fully charged state is short.

### (Charge control based on charge schedule)

The command acquisition unit 11 of the controller 10 acquires the charge schedule generated as described above, and outputs a charge control command regarding the charge power and the charge time according to the charge schedule from the charge control information output unit 12 to each EV charger 200 or the like. Then, the EV charger 200 that has acquired the charge control command outputs the charge power on the basis of the charge schedule to each EV 100 or the like using the ON/OFF control unit 220, and performs charging (step S15).

The remaining level estimation unit 23 performs the remaining battery level estimation process described above at an appropriate timing during charging on the basis of the charge schedule (step S15-1).

Then, the remaining level estimation unit 23 determines whether there is a difference between the remaining battery level estimated in step S15-1 and the first estimated value of the remaining battery level (step S15-2).

When it is determined in step S15-1 that there is a difference between the estimated remaining battery level and the estimated value of the first remaining battery level, the remaining battery level is corrected (step S17), and the information acquisition/condition setting unit 24 acquires the correction value (step S12). The charge schedule generation unit 25 corrects the charge schedule on the basis of the corrected remaining battery level (step S13), and the corrected charge schedule is output from the charge schedule output unit 26 to the controller 10 (step S14).

When it is determined in step S15-1 that there is no difference between the estimated remaining battery level and the estimated value of the first remaining battery level, it is determined whether or not there is a change in the EV that is the charge target in the generated charge schedule (step S15-3). The case where there is a change in the EV that is the charge target in the generated charge schedule is, for example, a case where there is an EV that has returned in the middle of the charging according to the charge schedule, or a case where there is an EV that has left before the completion of the charging according to the charge schedule.

In step S15-3, when it is determined that there is no change in the EV that is the charge target in the generated charge schedule, the charging according to the first charge schedule is performed over a predetermined charge time.

When it is determined in step S15-3 that there is a change in the EV that is the charge target in the generated charge schedule, the process returns to step S11, and a charge schedule including the EV that has returned and a charge schedule excluding the EV that has left are newly generated. At this time, the remaining level of the EV is estimated, and the result is acquired. The processes of steps S11 to S13 may be appropriately omitted when not required to be performed again. Further, even when the charge schedule is newly generated, there may be a case where it is not necessary to change the charge schedule for the EV that has returned or the EV other than the EV that has left.

The remaining battery level may be estimated a plurality of times during charging. In this case, the process returns from step S15-2 to step S15-1, and in step S15-2, it is determined whether there is a difference between the remaining battery level estimated in step S15-1 and the latest estimated value of the remaining battery level.

The process of step S15-3 is performed as an interrupt process when an EV newly connected to the EV charger 200 or the like is detected during charging, or the connection to the EV charger 200 or the like is canceled.

When a predetermined charge time elapses, the charging is completed (step S16).

As described above, even when the battery information cannot be acquired from the EV 100 side, the remaining battery level can be estimated, and an appropriate charge schedule that satisfies various conditions related to the electricity rate, the degradation of the battery, and the like can be generated on the basis of the estimated remaining battery level.

### (Modifications)

In the embodiment described above, the case where the charge characteristic information of the storage battery 110 or the like is held on the personal computer 20 side has been described. However, the storage battery 110 or the like mounted in each vehicle type of the EV 100 may have a different charge characteristic. In such a case, the personal computer 20 holds the charge characteristic information of the storage battery 110 or the like mounted in each vehicle type in a predetermined storage area in advance in the form of a table or the like. Then, a radio frequency identification (RF) tag that holds vehicle type information is provided in the charging port of the EV 100, and a reader/writer function is provided on the EV charger 200 side. Here, the vehicle type information corresponds to the characteristic identification information of the present invention.

With such a configuration, when the EV 100 is connected to the EV charger 200, the vehicle type information is acquired from the RF tag and output to the personal computer 20 through the controller 10. Thus, the vehicle type of the EV 100 is specified. The information acquisition unit 21 of the personal computer 20 acquires the charge characteristic data of the storage battery 110 or the like corresponding to the vehicle type specified by the vehicle type information from the plurality of pieces of charge characteristic data, and performs the remaining level estimation process using the charge characteristic data. Accordingly, even when the storage battery 110 or the like mounted in each vehicle type of the EV 100 has a different charge characteristic, it is possible to perform similar remaining level estimation and charge schedule generation. Here, the information acquisition unit 21 corresponds to the characteristic identification information acquisition unit of the present invention.

### [Second Embodiment]

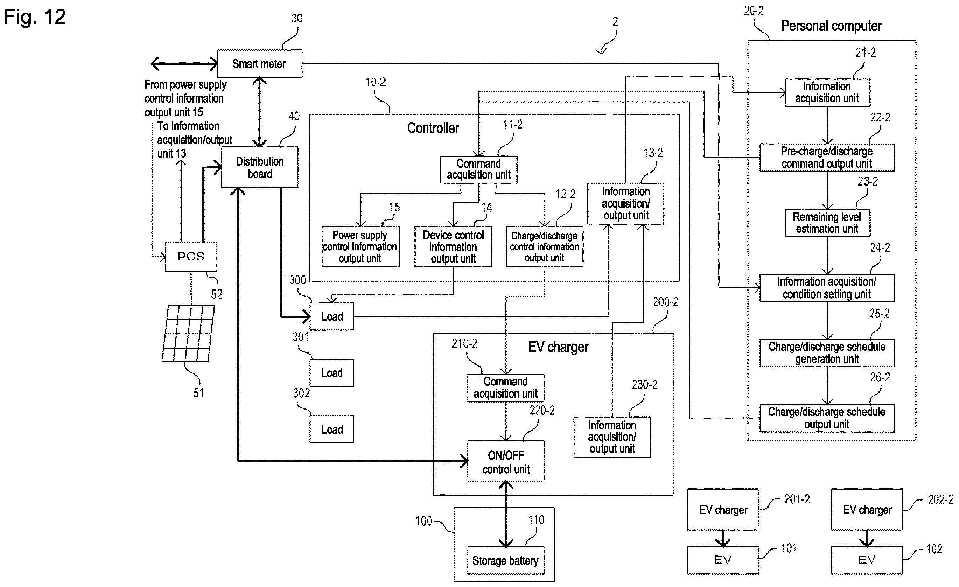

Fig. 12 illustrates a schematic configuration of a charge/discharge control system 2 according to a second embodiment. Components common to the charge control system 1 according to the first embodiment are denoted by the same reference numerals, and components similar to the charge control system 1 are denoted by numerals with suffixes, such as 10 and 10-2.

In the charge control system 1 according to the first embodiment, power supplied from a commercial power system is input to the EV charger 200 or the like via the smart meter 30, and the storage battery 110 or the like mounted in the EV 100 or the like are charged by the power output from the EV charger 30. In the charge/discharge control system 2 according to the second embodiment, in addition to the function of the EV charger 30, the EV charger 200-2 has a function of supplying power discharged from the storage battery 110 mounted in the EV 100 or the like to a load 300 or the like via the distribution board 40, and a function of conducting reverse power flow to the commercial power system via the distribution board 40 and selling the power. That is, the charge/discharge control system 2 is a system called vehicle-to-everything (V2X) that performs charging and discharging with the storage battery 110 or the like mounted in the EV 100 or the like. As described above, the charge/discharge control system 2 includes the charge control system 1 as a part thereof, and the charge control and the charge schedule generation for the storage battery 110 or the like mounted in the EV 100 or the like are similar to those of the charge control system 1, and hence the description thereof is omitted.

The charge/discharge control system 2 includes EV chargers (external charger/discharger or first charger/discharger) 200-2, 201-2, 202-2, a controller 10-2 that manages the EV charger 200 or the like, a personal computer 20-2 that performs various processes in cooperation with the controller 10-2, a smart meter 30, the distribution board 40, a Photovoltaic (PV) panel 51 and a power conditioning system (PCS; power conditioner) 52, and loads 300, 301, 302. The power supplied from the commercial power system is supplied to the EV charger 200-2 or the like via the smart meter 30 and the distribution board 40. AC power is also input to the distribution board 40 from the PCS 52 that converts DC power generated by the PV panel 51 into AC power. Further, the loads 300, 301, 302 are connected to the distribution board 40. These loads 300 and the like are, for example, electric devices such as home electric appliances, but the three loads are examples, and the number and types of loads are not limited thereto. In Fig. 12, one smart meter 30 and one distribution board 40 are provided. However, in the case of a composite facility such as an apartment building, a main distribution board, to which power received by the entire facility from a commercial power system or power generated in the facility is input, may be provided above the smart meter 30 and the distribution board 40 provided in each house.

By connecting the EV 100 or the like to each of the plurality of EV chargers 200-2 or the like, discharge can be performed from the storage batteries 110 or the like mounted in the plurality of EVs. The EV charger 200-2 includes a command acquisition unit 210, an ON/OFF control unit 220, and an information acquisition/output unit 230. The electric power discharged from the storage battery 110 or the like is input to each EV charger 200-2 or the like. In addition, the command acquisition unit 210-2 of the EV charger 200-2 acquires the discharge command from the controller 10-2, and outputs the command to the ON/OFF control unit 220. The ON/OFF control unit 220-2 of the EV charger 200-2 controls the ON/OFF switch on the basis of the discharge command to supply the power input to the EV charger 200 or the like to the load 300 or the like via the distribution board 40 or stop the supply. The information acquisition/output unit 230-2 acquires information of output power input from the EV 100 or the like to the EV charger 200-2 or the like and output from the EV charger 200-2 or the like to the distribution board 40, and outputs the information to an information acquisition/output unit 13 of the controller 10-2 described later. The smart meter 30 measures power consumption supplied from the connected commercial power system, and outputs power consumption information to the personal computer 20-2.

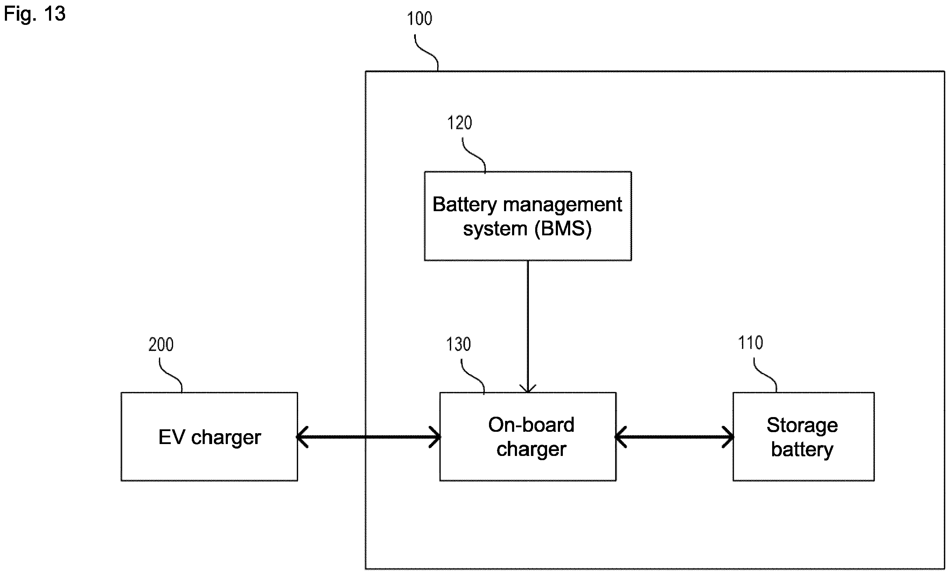

Fig. 13 is a diagram illustrating the EV charger 200-2 and the EV 100 taken out of Fig. 12. The same applies to the EV charger 201-2 and the EV 101, and the EV charger 202-2 and the EV 102, and hence the description thereof will be omitted. In Fig. 13 as well, the thick line indicates the flow of power, and the thin line indicates the flow of information.

As illustrated in Fig. 13, the EV 100 includes a battery management system (BMS) 120 and an on-board charger (on-vehicle charger and discharger or second charger and discharger) 130 as a configuration related to the charging and discharging of the storage battery 110. Since charging is the same as that described with reference to Fig. 2, the description thereof will be omitted, and discharging will be described below. The power discharged from the storage battery 110 or the like is input to the on-board charger 130 of the EV 100. The BMS 120 grasps the capacity information and the like of the storage battery 110, determines a discharge mode such as a CC mode, a CV mode, and a constant power (CP) mode on the basis of the capacity information and the like, and outputs a discharge command in the CC mode, the CV mode, the CP mode, or the like to the on-board charger 130. The on-board charger 130 receives a discharge command from the BMS 120 and discharges the storage battery 110 according to the received discharge command. At this time, the on-board charger 130 converts DC power discharged from the storage battery 110 into AC power and outputs the AC power to the EV charger 200. As described above, the power discharged from the storage battery 110 and output from the on-board charger 130 becomes a predetermined power value according to the discharge command of the BMS.

In the charge/discharge control system 2, the controller 10-2, which manages each EV charger 200-2 or the like, and the personal computer 20-2 perform various processes in cooperation with each other. The personal computer 20-2 and the controller 10-2 are communicably connected by a wired or wireless network. As a communication method between the personal computer 20-2 and the controller 10-2, for example, Ethernet (registered trademark) can be adopted, but the communication method is not limited thereto. Various functions realized in the personal computer 20-2 as described below may be realized in the controller 10-2, and the division of functions between the personal computer 20-2 and the controller 10-2 is not limited to the example described below. Here, the personal computer 20-2 corresponds to the battery capacity estimation device and the discharge schedule generation device of the present invention, but the battery capacity estimation device and the discharge schedule generation device of the present invention may be configured by the personal computer 20-2 and the controller 10-2.

The personal computer 20-2 includes an information acquisition unit 21-2, a pre-charge/discharge command output unit 22-2, a remaining level estimation unit 23-2, an information acquisition/condition setting unit 24-2, a charge/discharge schedule generation unit 25-2, and a charge/discharge schedule output unit 26-2. The hardware configuration of the personal computer 20-2 is similar to that of the personal computer 20, the description thereof will be omitted. Further, since the configuration related to the charging of the personal computer 20-2 is similar to that of the personal computer 20, the description thereof will be omitted, and the configuration related to discharging will be mainly described.

The information acquisition unit 21-2 acquires, from the information acquisition/output unit 13-2 of the controller 10-2, information such as whether the EV 100-2 or the like are connected to each EV charger 200-2 or the like, and the output power from each EV charger 200-2 or the like to the distribution board 40. The pre-charge/discharge command output unit 22-2 outputs a discharge time and a discharge power command for estimating a remaining level to the controller 10-2. The remaining level estimation unit 23 estimates the remaining battery level from the output power information from the EV charger 200-2 and the battery discharge characteristic of the storage battery 110 mounted in the EV 100. The information acquisition/condition setting unit 24-2 acquires the estimated remaining battery level information, the load-related information such as the rated power, the power consumption, and the operating state of the load 300 from the controller 10-2, and the power consumption information from the smart meter. The information acquisition/condition setting unit 24-2 also sets conditions such as the target power, the rated output of the EV charger 200-2, and the predetermined number. The charge/discharge schedule generation unit 25-2 calculates the discharge power and the discharge time of each EV 100 or the like from the acquired information and the set conditions, and creates a discharge schedule or corrects the created discharge schedule. The charge/discharge schedule output unit 26-2 outputs a charge/discharge schedule to the controller 10-2. The target power is power targeted for reducing the maximum power when the discharge schedule is generated, and may be a power target for selling power to the commercial power system. Here, the information acquisition unit 21-2 corresponds to the third output power value acquisition unit of the present invention.

The controller 10-2 includes a command acquisition unit 11-2, a charge/discharge control information output unit 12-2, an information acquisition/output unit 13-2, a device control information output unit 14, and a power supply control information output unit 15. The command acquisition unit 11-2 acquires a pre-discharge command from the pre-charge/discharge command output unit 22-2 of the personal computer 20-2, and acquires a discharge schedule from the charge/discharge schedule output unit 26-2. The charge/discharge control information output unit 12-2 outputs discharge control information such as discharge time and discharge power to the EV charger 200. The information acquisition/output unit 13-2 acquires information such as output power from the EV charger 200, information such as output power from the PCS 52, and load-related information such as rated power, power consumption, and an operating state from the load 300 or the like, and outputs the information to the personal computer 20-2. The device control information output unit 14 outputs various types of control information for instructing operation, stop, mode change, and the like, acquired by the command acquisition unit 11-2, to a device corresponding to the load 300 or the like. The power supply control information output unit 15 outputs various types of control information such as power supply start, stop, and output increase/decrease, acquired by the command acquisition unit 11-2, to the PV panel 51 and the PCS 52, which are power supplies. The power supply included in the charge/discharge control system 2 is not limited thereto, and may be a stationary storage battery, a fuel cell, a wind power generation apparatus, or the like, and is not limited thereto. The stationary storage battery functions as a power source when being discharged, but also functions as a type of load that receives power supply when being charged. Here, the controller 10-2 may be a home energy management system (HEMS) controller that controls the PCS 52 and the like or acquires the information thereof, such as the load 300 that is a device compatible with the HEMS. Further, the controller 10-2 may be a building energy management system (BEMS) controller or a factory energy management system (FEMS) controller depending on the facility in which the load 300 or the like are provided. As a communication method between the controller 10-2 and each EV charger 200-2 or the like, for example, ECHONET Lite can be adopted, but the communication method is not limited thereto.

### (Remaining battery level estimation method)

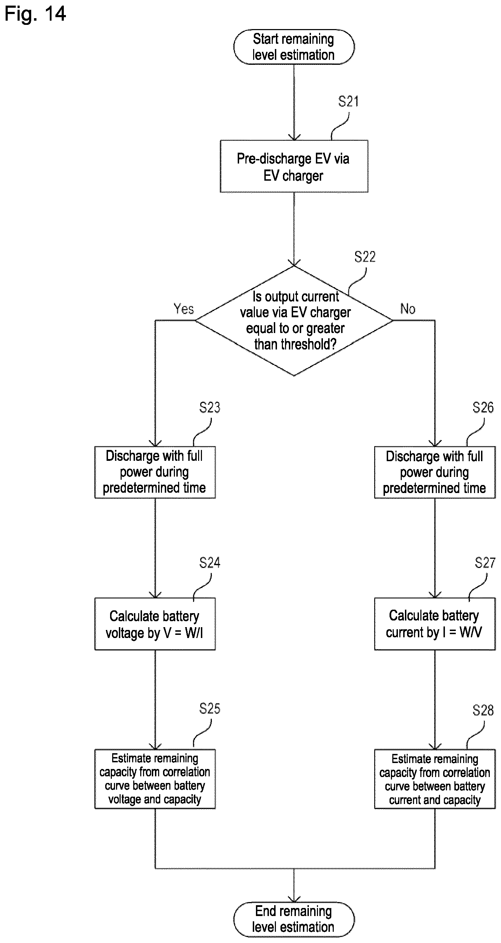

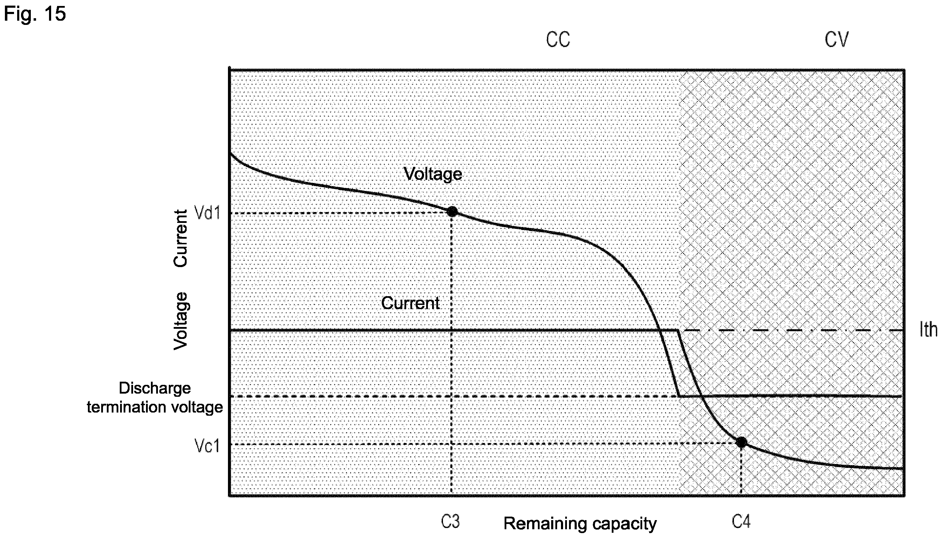

Hereinafter, a remaining battery level estimation method executed by the personal computer 20-2 and the controller 10-2 will be described. Fig. 14 is a flowchart for explaining a processing procedure for estimating a remaining battery level, and Fig. 15 is a diagram for explaining a principle for discharge mode determination and a principle for capacity estimation. Here, the remaining battery level estimation method corresponds to the battery capacity estimation method of the present invention.

The remaining battery level estimation process roughly includes two phases. That is, the discharge control of the storage battery 110 connected to the EV charger 200 includes two phases: a discharge mode determination process (first phase) of determining whether the discharge control is being performed in a constant current (CC) mode of holding the discharge current at a predetermined current value or a constant voltage (CV) mode of holding the discharge voltage at a predetermined voltage value; and a remaining battery level estimation process (second phase) in the determined CC mode or CV mode. As the remaining battery level estimation process, the first phase and the second phase may be executed, or the first phase may be omitted, and only the remaining battery level estimation process in the CC mode of the second phase, or the remaining battery level estimation process in the CC mode or the remaining battery level estimation process in the CV mode may be executed. When the discharge mode determination process is not executed, instead, it may be determined which mode of the capacity estimation result will be used or which mode of the remaining battery level estimation process will be executed on the basis of the driving distance, the use time, and the like of the EV 100 or the like. Here, the CC mode and the CV mode correspond to the first discharge mode and the second discharge mode of the present invention, respectively.

For example, the information acquisition unit 21-2 of the personal computer 20-2 starts the remaining battery level estimation process with the acquisition of the information indicating that the EV 100 or the like has been connected to any EV charger 200-2 or the like from the controller 10-2 as a trigger.

First, the pre-charge/discharge command output unit 22-2 outputs a first-phase pre-discharge command (first pre-discharge command) to the controller 10-2. The first pre-discharge command includes a command related to discharge time and discharge power. In the controller 10-2, the command acquisition unit 11-2 acquires the first pre-discharge command, and the charge/discharge control information output unit 12-2 outputs the first pre-discharge control command for the first-phase pre-discharging to the EV charger 200-2. In the EV charger 200-2, the command acquisition unit 210 acquires the first pre-discharge control command, and the ON/OFF control unit 220 controls the ON/OFF switch to pre-discharge predetermined power from the storage battery 110 over a predetermined time according to the first pre-discharge control command including information on the discharge time and the discharge power (step S21). Here, the first-phase pre-discharging corresponds to the second discharging and the second discharge step of the present invention.

Next, the EV charger 200-2 acquires the current value output from the storage battery 110 and input to the EV charger 200 via the on-board charger 130, and outputs the current value from the information acquisition/output unit 230-2 to the controller 10-2. The controller 10-2 outputs the above-described information described above, acquired by the information acquisition/output unit 13-2, to the personal computer 20-2. The remaining level estimation unit 23-2 of the personal computer 20-2 compares the output current value output from the storage battery 110 and input to the EV charger 200-2 via the on-board charger 130 acquired by the information acquisition unit 21-2 with a predetermined threshold, and determines whether or not the output current value is equal to or greater than the predetermined threshold, that is, whether the discharge mode of the storage battery is the CC mode or the CV mode (step S22). That is, when the output current value output from the storage battery 110 via the on-board charger 130 is equal to or greater than the threshold, it is determined that the mode is the CC mode, and when the output current value is less than the threshold, it is determined that the mode is the CV mode. For example, when the storage battery 110 or the like has the discharge characteristic illustrated in Fig. 15, a current value Ith in Fig. 15 can be set as the threshold. In the first-phase pre-discharging, the output current value output from the storage battery 110 via the on-board charger 130 corresponds to the first output current value of the present invention. The information acquisition unit 21-2 and the remaining level estimation unit 23-2 of the personal computer 20-2 correspond to the first output current value acquisition unit and the mode determination unit of the present invention, respectively. Step S22 corresponds to the mode determination step of the present invention.

When it is determined in step S22 that the output current value output from the storage battery 110 via the on-board charger 130 and input to the EV charger 200-2 is equal to or greater than the predetermined threshold, that is, when it is determined that the discharge control for the storage battery 110 is in the CC mode, the process proceeds to step S23. At this time, the pre-charge/discharge command output unit 22-2 outputs a second-phase pre-discharge command (second pre-discharge command) to the controller 10-2. The second pre-discharge command includes a command related to discharge time and discharge power. In the controller 10-2, the command acquisition unit 11-2 acquires the second pre-discharge command, and the charge/discharge control information output unit 12-2 outputs the second pre-discharge control command for the second-phase pre-discharging to the EV charger 200-2. In the EV charger 200-2, the command acquisition unit 210 acquires the second pre-discharge control command, and the ON/OFF control unit 220 controls the ON/OFF switch to discharge the storage battery 110 with full power over a predetermined time according to the second pre-discharge control command including information on the discharge time and the discharge power (step S23). Here, the second-phase pre-discharging corresponds to the first discharging and the first discharge step of the present invention.

The full power is output from the storage battery 110 in step S23 and is input to the EV charger 200-2 via the on-board charger 130, allowing the EV charger 200-2 to know the output power value from the storage battery 110. In addition, the discharge current is also known since the discharging is being performed in the CC mode. Therefore, assuming that the power at which the storage battery 110 is discharged is W and the discharge current is I, since W and I are known, the remaining level estimation unit 23-2 calculates the discharge voltage V by V = W/I (step S24). Here, W, I, and V correspond to the third output power value, the predetermined current value, and the discharge voltage value of the present invention, respectively. Step S23 corresponds to the third output power value acquisition step of the present invention. Here, although the discharge voltage V is calculated in step S24, the discharge power can be calculated when the discharge current and the discharge voltage are known. Therefore, when correlation curves between the discharge current/discharge power and the capacity or a table associating these is acquired in advance as the discharge characteristic information on the basis of the correlation curves between the charge current/charge power and the capacity, step S24 of calculating the discharge voltage can be omitted, and the estimation of the remaining capacity in step S25 can be performed (the same applies to steps S27 and S28 in the CV mode).

The remaining level estimation unit 23-2 estimates the remaining capacity of the storage battery 110 from the correlation curve between the discharge voltage and the capacity (step S25), and ends the process. The remaining capacity estimation of the storage battery 110 will be described later together with the case where the CV mode is determined. Here, the processes from step S23 to step S25 correspond to the third estimation process, the third estimation process step, and the capacity estimation step of the present invention. Here, although the discharge voltage V is calculated in step S24, the discharge power can be calculated when the discharge current and the discharge voltage are known. Therefore, when correlation curves between the discharge current/discharge power and the capacity or a table associating these is acquired in advance as the discharge characteristic information on the basis of the correlation curves between the charge current/charge power and the capacity, step S24 of calculating the discharge voltage can be omitted, and the estimation of the remaining capacity in step S25 can be performed (the same applies to steps S27 and S28 in the CV mode).

When it is determined in step S22 that the output current value, which is discharged from the storage battery 110, input to the EV charger 200-2, and output from the EV charger 200-2 to the distribution board 40, is less than the predetermined threshold, that is, when it is determined that the discharge control for the storage battery 110 is in the CV mode, the process proceeds to step S26. At this time, the pre-charge/discharge command output unit 22-2 outputs a second-phase pre-discharge command (second pre-discharge command) to the controller 10-2. The second pre-discharge command includes a command related to discharge time and discharge power. In the controller 10-2, the command acquisition unit 11-2 acquires the second pre-discharge command, and the charge/discharge control information output unit 12-2 outputs the second pre-discharge control command for the second-phase pre-discharging to the EV charger 200-2. In the EV charger 200-2, the command acquisition unit 210-2 acquires the second pre-discharge control command, and the ON/OFF control unit 220 controls the ON/OFF switch to discharge the storage battery 110 with full power over a predetermined time according to the second pre-discharge control command including information on the discharge time and the discharge power (step S26).

The full power is output from the storage battery 110 in step S26 and is input to the EV charger 200-2 via the on-board charger 130, allowing the EV charger 200-2 to know the output power value from the storage battery 110. In addition, since the storage battery 110 is discharged in the CV mode, the voltage is also known. Therefore, assuming that the power at which the storage battery 110 is discharged is W and the discharge voltage is V, since W and V are known, the remaining level estimation unit 23 calculates the battery current I by V = W/V (step S27). Here, W, V, and I correspond to the third output power value, the predetermined voltage value, and the discharge current value of the present invention, respectively. Here, step S26 corresponds to the third output power value acquisition step of the present invention.

The remaining level estimation unit 23-2 estimates the remaining capacity of the storage battery 110 from the correlation curve between the discharge current and the capacity (step S28), and ends the process. Here, the processes from step S26 to step S28 correspond to the fourth estimation process, the fourth estimation process, and the capacity estimation step of the present invention. In the flowchart illustrated in Fig. 14, the first-phase pre-discharging (step S21) and the second-phase pre-discharging (steps S23 and S26) are separately, described but pre-discharging for a predetermined time (e.g., about 1 minute) may also serve as the first-phase pre-discharging and the second-phase pre-discharging. When the first-phase pre-discharging and the second-phase pre-discharging are performed integrally as described above, the first discharging and the second discharging of the present invention correspond to the same discharge.

### (Principle for remaining battery level estimation)

The principle for the remaining battery level estimation in each mode will be described with reference to Fig. 15. Fig. 15 is a discharge characteristic graph illustrating changes in voltage and current when constant voltage/constant current discharging is performed on the storage battery 110, with the remaining capacity (the remaining capacity is on the decrease from the left side to the right side) on the horizontal axis and the voltage (V) and the current (mA) on the vertical axis. A range indicated by a dot hatching pattern on the left side of Fig. 15 represents the discharging in the CC mode, and a range indicated by a lattice hatching pattern on the right side of Fig. 15 represents the discharging in the CV mode. In the discharging in the CC mode, the discharge current is constant, and the discharge voltage decreases as the discharge progresses and the battery capacity decreases. In the discharging in the CV mode, the discharge voltage is constant, and the discharge current decreases as the discharge progresses and the battery capacity decreases. Here, the discharge characteristic graph corresponds to the discharge characteristic information of the present invention, the discharge characteristic graph including the range indicated by the dot hatching pattern on the left side of the discharge characteristic graph corresponds to the first discharge characteristic information of the present invention, and the discharge characteristic graph including the range indicated by the grid hatching pattern on the right side of the discharge characteristic graph corresponds to the second discharge characteristic information of the present invention.

As illustrated in Fig. 15, the remaining capacity of the storage battery 110 can be estimated from the discharge characteristic graph indicating the discharge characteristics. The discharge characteristic graph illustrated in Fig. 15 includes a correlation curve indicating a correlation between the discharge voltage and the remaining capacity and a correlation curve indicating a correlation between the discharge current and the remaining capacity. When it is determined in step S22 that the discharge mode is the CC mode and the voltage calculated from the power and the current in step S24 is Vd1, the remaining capacity can be estimated as C3 as the value on the horizontal axis at the point corresponding to the discharge voltage Vd1 on the correlation curve between the discharge voltage and the remaining capacity of the storage battery. As described above, since the discharge voltage and the remaining capacity calculated in step S24 have a correlation, a correlation curve, which is information indicating a correlation between the discharge voltage and the remaining capacity, is held in a predetermined storage area. Thereby, in step S25, the remaining level estimation unit 23-2 can estimate the remaining capacity from the calculated discharge voltage and the correlation curve between the read discharge voltage and the remaining capacity. The correlation curve may be held in advance in a predetermined storage area as described above, may be input from the input unit such as the keyboard or the touch panel, or may be acquired from an external server via the network. The correlation curve between the discharge voltage and the remaining capacity is included in the first discharge characteristic information of the present invention. Reading the discharge characteristic graph including the correlation curve between the discharge voltage and the battery capacity from a predetermined storage area, receiving an input from the input unit, or acquiring the discharge characteristic graph via the network corresponds to the discharge characteristic information acquisition step of the present invention.

When it is determined in step S22 that the discharge mode is the CV mode, and the current calculated from the power and the voltage in step S27 is Vc1, the remaining capacity can be estimated as C4 as the value on the horizontal axis at the point corresponding to the discharge current Vc1 on the correlation curve between the discharge current and the remaining level of the storage battery. As described above, since the discharge current and the remaining capacity calculated in step S27 have a correlation, a correlation curve, which is information indicating a correlation between the discharge current and the remaining capacity, is held in a predetermined storage area. Thereby, in step S28, the remaining level estimation unit 23-2 can estimate the remaining capacity from the calculated discharge current and the correlation curve between the read discharge current and the remaining capacity. The correlation curve may be held in advance in a predetermined storage area as described above, may be input from the input unit such as the keyboard or the touch panel, or may be acquired from an external server via the network. The correlation curve between the discharge current and the remaining capacity is included in the second discharge characteristic information of the present invention. Reading the discharge characteristic graph that includes the correlation curve between the discharge current and the battery capacity from a predetermined storage area, receiving an input from the input unit, or acquiring the discharge characteristic graph via the network corresponds to the discharge characteristic information acquisition step of the present invention.

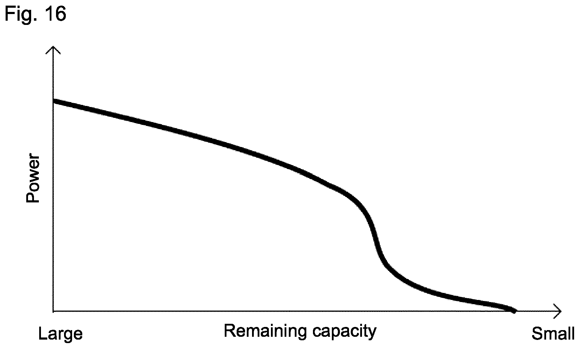

As described above, the discharge characteristic information is not limited to the discharge characteristic graph in which the discharge current and the discharge voltage are associated with the remaining capacity of the storage battery 110 or the like. Information regarding the discharge characteristics such as the discharge characteristic graph may be input from the input unit such as the keyboard or the touch panel, may be held in advance in a predetermined storage area, or may be acquired from an external server via the network. As illustrated in Fig. 16, when the discharge characteristic information is a correlation graph (here, the horizontal axis represents the remaining capacity of the storage battery, and the vertical axis represents the discharge power) in which the discharge power and the remaining capacity are associated with each other, the remaining capacity of the storage battery 110 can be estimated by acquiring the output power value that is discharged from the storage battery 110 and output from the EV charger 200-2 via the on-board charger 130 according to the full output discharge command to the EV charger 200-2.

By estimating the remaining battery level in this manner, the remaining battery level can be estimated even when the battery information cannot be acquired from the EV 100 side.

### (Generation of discharge schedule)

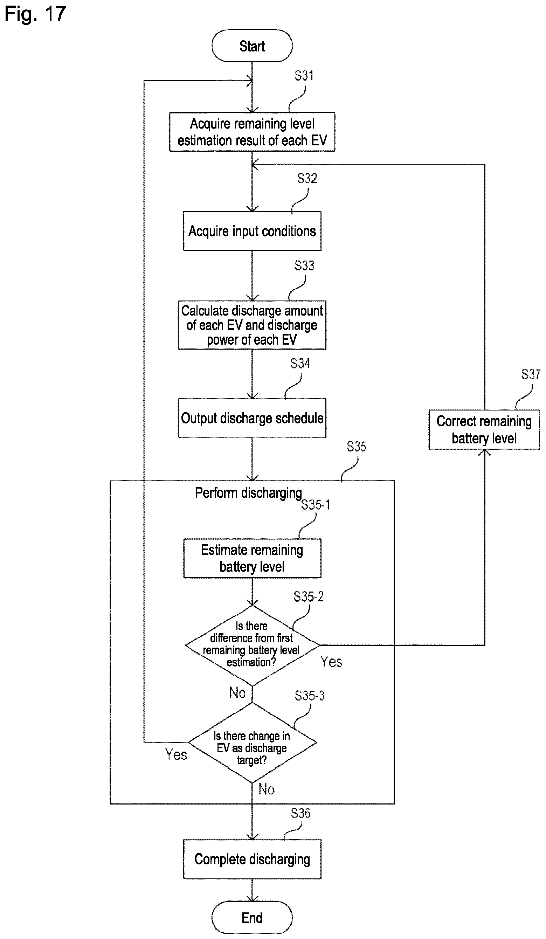

Hereinafter, a method for generating a discharge schedule and a discharge control method based on the generated discharge schedule, both executed by the personal computer 20-2 and the controller 10-2, will be described. Fig. 17 is a flowchart for explaining a process procedure for generating a discharge schedule and a process procedure for performing discharge control based on the generated charge schedule.

First, the information acquisition/condition setting unit 24-2 acquires the remaining level estimation result of the storage battery 110 mounted in each EV 100 or the like connected to the EV charger 200-2 (step S31).

Next, the information acquisition/condition setting unit 24-2 acquires input conditions (step S32). The input conditions are the number of EVs 100 or the like to be discharged, the rated capacity of the storage battery 110 or the like mounted in the EV 100 or the like, the rated output power of the EV charger 200, the dischargeable time, the target power, the remaining level lower limit value set from the viewpoint of degradation prevention, business continuity plan (BCP), and the like. These pieces of information may be input from the input unit such as the keyboard or the touch panel, may be held in advance in a predetermined storage area, or may be acquired from an external server via the network. Here, the information acquisition/condition setting unit 24-2 corresponds to the condition acquisition unit of the present invention. Here, contract power is set as the target power, but the value that can be set as the target power is not limited thereto. For example, the target value of the discharge power or the amount of discharge power can be set such that a value, obtained by subtracting the power generated by the PV panel 51 or the power discharged from the EV 100 or the like from the power consumption of the load 300 or the like, does not exceed the target power. At this time, the target value may be set by acquiring the current operating state of the load 300 or the like through the controller 10-2, or the target value may be set using the power generated by the PV panel 51 in the same time zone in the past or a predicted value obtained from an actual value of the power consumption of the load 300 or the like.

Next, the charge/discharge schedule generation unit 25-2 calculates the discharge amount of the storage battery 110 or the like mounted in each EV 100 or the like and the discharge power of the storage battery 110 or the like of each EV 100 or the like on the basis of the acquired remaining level estimation result of the storage battery 110 or the like and input conditions, and generates a discharge schedule including these (step S33). As for a specific discharge schedule, as in the charge schedule described in the first embodiment, various discharge schedules are possible on the basis of input conditions.

Then, the charge/discharge schedule output unit 26-2 outputs the discharge schedule generated in this manner to the controller 10-2.

### (Discharge control based on discharge schedule)

The command acquisition unit 11-2 of the controller 10-2 acquires the discharge schedule generated as described above, and outputs a discharge control command regarding the discharge power and the discharge time according to the discharge schedule from the charge/discharge control information output unit 12-2 to each EV charger 200-2 or the like. Then, the EV charger 200-2 that has acquired the discharge control command outputs the discharge power on the basis of the discharge schedule from each EV 100 or the like by the ON/OFF control unit 220-2, and performs discharge (step S35).

The remaining level estimation unit 23-2 performs the remaining battery level estimation process described above at an appropriate timing during discharging on the basis of the discharge schedule (step S35-1).

Then, the remaining level estimation unit 23-2 determines whether there is a difference between the remaining battery level estimated in step S35-1 and the first estimated value of the remaining battery level (step S35-2).

When it is determined in step S35-1 that there is a difference between the estimated remaining battery level and the initial estimated value of the remaining battery level, the remaining battery level is corrected (step S37), the information acquisition/condition setting unit 24-2 acquires the correction value (step S32). The charge/discharge schedule generation unit 25-2 corrects the discharge schedule on the basis of the corrected remaining battery level (step S33), and the charge/discharge schedule output unit 26-2 outputs the corrected discharge schedule to the controller 10-2 (step S34).

When it is determined in step S35-1 that there is no difference between the estimated remaining battery level and the initial estimated value of the remaining battery level, it is determined whether there is a change in the EV that is the discharge target in the generated discharge schedule (step S35-3). The case where there is a change in the EV that is the discharge target in the generated discharge schedule is, for example, a case where there is an EV that has returned in the middle of the discharging according to the discharge schedule, or a case where there is an EV that has left before the completion of the discharging according to the discharge schedule.

When it is determined in step S35-3 that there is no change in the EV that is the discharge target in the generated discharge schedule, the discharging according to the first discharge schedule is performed over a predetermined discharge time.

When it is determined in step S35-3 that there is a change in the EV that is the discharge target in the generated discharge schedule, the process returns to step S31, and a discharge schedule including the EV that has returned and a discharge schedule excluding the EV that has left are newly generated. At this time, the remaining level of the EV is estimated, and the result is acquired. The processes of steps S31 to S33 may be appropriately omitted when not required to be performed again. Further, even when the discharge schedule is newly generated, there may be a case where it is not necessary to change the discharge schedule for the EV that has returned or the EV other than the EV that has left.

The remaining battery level may be estimated a plurality of times during discharging. In this case, the process returns from step S35-2 to step S35-1, and in step S35-2, it is determined whether there is a difference between the remaining battery level estimated in step S35-1 and the latest estimated value of the remaining battery level.

The process of step S35-3 is performed as an interrupt process when an EV newly connected to the EV charger 200-2 or the like is detected during discharging, or the connection to the EV charger 200-2 or the like is canceled.

Further, similarly to step S35-3, a process of newly generating the discharge schedule may be performed according to the operating state of the load 300 or the like and the power generation state of the PV panel 51.

When the predetermined discharge time elapses, the discharging is completed (step S36).

As described above, even when the battery information cannot be acquired from the EV 100 side, the remaining battery level can be estimated, and an appropriate discharge schedule that satisfies various conditions related to the electricity rate, the power generation state of the PV panel 51, the operating state of the load 300, and the like can be generated on the basis of the estimated remaining battery level.

In the present embodiment as well, the personal computer 20-2 may hold the discharge characteristic information of the storage battery 110 or the like mounted in each vehicle type in a predetermined storage area in advance in the form of a table or the like. Moreover, an RF tag that holds vehicle type information may be provided in the charging port of the EV 100, and a reader/writer function may be provided on the EV charger 200-2 side. Here, the vehicle type information corresponds to the characteristic identification information of the present invention.

With such a configuration, when the EV 100 is connected to the EV charger 200-2, the vehicle type information is acquired from the RF tag and output to the personal computer 20-2 through the controller 10-2. Thus, the vehicle type of the EV 100 is specified. The information acquisition unit 21-2 of the personal computer 20-2 acquires the discharge characteristic data of the storage battery 110 or the like corresponding to the vehicle type specified by the vehicle type information from the plurality of pieces of discharge characteristic data, and performs the remaining level estimation process using the discharge characteristic data. Accordingly, even when the storage battery 110 or the like mounted in each vehicle type of the EV 100 has a different discharge characteristic, it is possible to perform similar remaining level estimation and discharge schedule generation. Here, the information acquisition unit 21 corresponds to the characteristic identification information acquisition unit of the present invention.

In the second embodiment, the case of discharging from the storage battery 110 or the like mounted in the EV 100 or the like has been described. However, as illustrated in Fig. 12, when a plurality of EV chargers 200-2, 201-2, 203-2 are provided, charging or discharging can be performed in parallel for each storage battery, such as discharging from storage batteries mounted in EVs connected to some EV chargers and charging storage batteries mounted in EVs connected to other EV chargers. Here, the storage battery that is charged is in a relationship to receive power supply from the storage battery that is discharged, and functions as a type of load. In this case, the charge/discharge schedule generation unit 25-2 generates a charge/discharge schedule for charging or discharging each storage battery. At this time, the charge/discharge schedule includes the charge schedule described in the first embodiment and the discharge schedule described in the second embodiment. In this way, it is possible to generate a flexible charge/discharge schedule according to the remaining capacity of each storage battery, such as discharging from a storage battery having a large remaining capacity and charging a storage battery having a small remaining capacity.

In the first embodiment, the case has been described where the charge schedule is generated on the basis of the remaining capacity of the storage battery 110 or the like estimated by the remaining battery level estimation method described with reference to Fig. 3. However, the charge schedule can be similarly generated on the basis of the remaining capacity of the storage battery 110 or the like estimated by the remaining battery level estimation method described with reference to Fig. 14 of the second embodiment. In addition, in the second embodiment, the case has been described where the discharge schedule is generated on the basis of the remaining capacity of the storage battery 110 or the like estimated by the remaining battery level estimation method described with reference to Fig. 14. However, the discharge schedule can be similarly generated on the basis of the remaining capacity of the storage battery 110 or the like estimated by the remaining battery level estimation method described with reference to Fig. 3 of the first embodiment.

### <Supplementary note 1 >

A battery capacity estimation device (20) that estimates battery capacity of a storage battery, the battery capacity estimation device including:
a characteristic information acquisition unit (21) that acquires charge characteristic information of the storage battery in which at least one of a charge current, a charge voltage, or a charge power for charging the storage battery is associated with the battery capacity; and
a capacity estimation unit (23) that performs an estimation process of outputting power of a first output power value to the storage battery over a predetermined time necessary for estimating the battery capacity to perform first charging and estimating the battery capacity on the basis of at least the first output power value.

### DESCRIPTION OF SYMBOLS

- 1: charge control system
- 20: personal computer
- 21: information acquisition unit
- 23: remaining level estimation unit

## Claims

1. A battery capacity estimation device that estimates battery capacity of a storage battery, the battery capacity estimation device comprising:
a characteristic information acquisition unit configured to acquire charge characteristic information of the storage battery in which at least one of a charge current, a charge voltage, or a charge power for charging the storage battery is associated with the battery capacity; and
a capacity estimation unit configured to perform an estimation process of outputting power of a first output power value to the storage battery over a predetermined time necessary for estimating the battery capacity to perform first charging and estimating the battery capacity on a basis of at least the first output power value.

2. The battery capacity estimation device according to claim 1, wherein
the characteristic information acquisition unit acquires first charge characteristic information that is the charge characteristic information in which the charge voltage and the battery capacity are associated with each other when the charge current is held at a predetermined current value, and
the capacity estimation unit performs a first estimation process of estimating the battery capacity on a basis of the first output power value, the predetermined current value, and the first charge characteristic information.

3. The battery capacity estimation device according to claim 2, further comprising:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a first charge mode in which the charge current is held at the predetermined current value on a basis of a direction of a change in the second output power value,
wherein the capacity estimation unit performs the first estimation process when the first charge mode is determined.

4. The battery capacity estimation device according to claim 1, wherein
the characteristic information acquisition unit acquires second charge characteristic information that is the charge characteristic information in which the charge current and the battery capacity are associated with each other when the charge voltage is held at a predetermined voltage value, and
the capacity estimation unit performs a second estimation process of estimating the battery capacity on a basis of the first output power value, the predetermined voltage value, and the second charge characteristic information.

5. The battery capacity estimation device according to claim 4, further comprising:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a second charge mode in which the charge voltage is held at the predetermined voltage value on a basis of a direction of a change in the second output power value,
wherein the capacity estimation unit performs the second estimation process when the second charge mode is determined.

6. The battery capacity estimation device according to claim 2, wherein
the characteristic information acquisition unit acquires second charge characteristic information that is the charge characteristic information in which the charge current and the battery capacity are associated with each other when the charge voltage is held at a predetermined voltage value, and
the capacity estimation unit performs a second estimation process of estimating the battery capacity on a basis of the first output power value, the predetermined voltage value, and the second charge characteristic information.

7. The battery capacity estimation device according to claim 6, further comprising:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a second charge mode in which the charge voltage is held at the predetermined voltage value on a basis of a direction of a change in the second output power value,
wherein the capacity estimation unit performs the second estimation process when the second charge mode is determined.

8. The battery capacity estimation device according to claim 6, further comprising:
a second output power value acquisition unit configured to acquire a second output power value that is output to the storage battery in second charging in which the storage battery is charged over a predetermined time necessary for determining a charge mode for charging the storage battery; and
a mode determination unit configured to determine whether the charge mode is a first charge mode in which the charge current is held at the predetermined current value or a second charge mode in which the charge voltage is held at the predetermined voltage value on a basis of a direction of a change in the second output power value,
wherein the capacity estimation unit performs the first estimation process when the first charge mode is determined, and performs the second estimation process when the second charge mode is determined.

9. The battery capacity estimation device according to claim 2, wherein
the characteristic information acquisition unit acquires second charge characteristic information that is the charge characteristic information in which the charge current and the battery capacity are associated with each other when the charge voltage is held at a predetermined voltage value,
the capacity estimation unit performs a second estimation process of estimating the battery capacity on a basis of the first output power value, the predetermined voltage value, and the second charge characteristic information,
the battery capacity estimation device further comprises:
a second output power value acquisition unit configured to acquire a second output power value that is output to the storage battery in second charging in which the storage battery is charged over a predetermined time necessary for determining a charge mode for charging the storage battery; and
a mode determination unit configured to determine that the charge mode is a first charge mode in which the charge current is held at the predetermined current value on a basis of a direction of a change in the second output power value, and
the capacity estimation unit performs the first estimation process when the first charge mode is determined.

10. The battery capacity estimation device according to any one of claims 1 to 9, further comprising
a characteristic identification information acquisition unit configured to acquire characteristic identification information associated with each of a plurality of pieces of the charge characteristic information,
wherein the characteristic information acquisition unit acquires the charge characteristic information specified by the characteristic identification information.

11. A charge schedule generation device that generates a charge schedule for charging a storage battery, the charge schedule generation device comprising:
a characteristic information acquisition unit configured to acquire charge characteristic information of the storage battery in which at least one of a charge current, a charge voltage, or a charge power for charging the storage battery is associated with battery capacity of the storage battery;
a capacity estimation unit configured to perform an estimation process of outputting power of a first output power value to the storage battery over a predetermined time necessary for estimating the battery capacity to perform first charging and estimating the battery capacity on a basis of at least the first output power value;
a condition acquisition unit configured to acquire a condition related to a charge time for charging the storage battery and/or a condition including a target power to be a target during charging; and
a charge schedule generation unit configured to generate a charge schedule on a basis of the battery capacity estimated and the condition.

12. The charge schedule generation device according to claim 11, wherein
the condition related to the charge time includes setting, as the charge time, an entire period of a chargeable time that is a time during which each of a plurality of the storage batteries is chargeable, and
the condition related to the target power includes that a total of the charge power of the plurality of the storage batteries over the entire period of the chargeable time does not exceed an upper limit value.

13. A charge schedule generation device that generates a charge schedule for charging a storage battery, the charge schedule generation device comprising:
a characteristic information acquisition unit configured to acquire discharge characteristic information of the storage battery in which at least one of a discharge current, a discharge voltage, or a discharge power discharged from the storage battery is associated with battery capacity of the storage battery;
a third output power value acquisition unit configured to acquire a third output power value output from the storage battery in first discharging in which the storage battery is discharged over a predetermined time necessary for estimating the battery capacity;
a capacity estimation unit configured to perform an estimation process of estimating the battery capacity on a basis of at least the third output power value;
a condition acquisition unit configured to acquire a condition related to a charge time for charging the storage battery and/or a condition including a target power to be a target during charging; and
a charge schedule generation unit configured to generate a charge schedule on a basis of the battery capacity estimated and the condition.

14. A battery capacity estimation method for estimating battery capacity of a storage battery, the battery capacity estimation method comprising:
a charge characteristic information acquisition step of acquiring charge characteristic information of the storage battery in which at least one of a charge current, a charge voltage, or a charge power for charging the storage battery is associated with the battery capacity;
a first charge step of outputting power of a first output power value to the storage battery over a predetermined time necessary for estimating the battery capacity to perform first charging; and
a capacity estimation step of performing an estimation process of estimating the battery capacity on a basis of at least the first output power value.

15. A battery capacity estimation device that estimates battery capacity of a storage battery, the battery capacity estimation device comprising:
a characteristic information acquisition unit configured to acquire discharge characteristic information of the storage battery in which at least one of a discharge current, a discharge voltage, or a discharge power discharged from the storage battery is associated with the battery capacity;
a third output power value acquisition unit configured to acquire a third output power value output from the storage battery in first discharging in which the storage battery is discharged over a predetermined time necessary for estimating the battery capacity; and
a capacity estimation unit configured to perform an estimation process of estimating the battery capacity on a basis of at least the third output power value.

16. The battery capacity estimation device according to claim 15, wherein
the characteristic information acquisition unit acquires first discharge characteristic information that is the discharge characteristic information in which the discharge voltage and the battery capacity are associated with each other when the discharge current is held at a predetermined current value, and
the capacity estimation unit performs a third estimation process of estimating the battery capacity on a basis of the third output power value, the predetermined current value, and the first discharge characteristic information.

17. The battery capacity estimation device according to claim 16, further comprising:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a first discharge mode in which the discharge current is held at the predetermined current value,
wherein the capacity estimation unit performs the third estimation process when the first discharge mode is determined.

18. The battery capacity estimation device according to claim 15, wherein
the characteristic information acquisition unit acquires second discharge characteristic information that is the discharge characteristic information in which the discharge current and the battery capacity are associated with each other when the discharge voltage is held at a predetermined voltage value, and
the capacity estimation unit performs a fourth estimation process of estimating the battery capacity on a basis of the third output power value, the predetermined voltage value, and the second discharge characteristic information.

19. The battery capacity estimation device according to claim 18, further comprising:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a second discharge mode in which the discharge voltage is held at the predetermined voltage value,
wherein the capacity estimation unit performs the fourth estimation process when the second discharge mode is determined.

20. The battery capacity estimation device according to claim 16, wherein
the characteristic information acquisition unit acquires second discharge characteristic information that is the discharge characteristic information in which the discharge current and the battery capacity are associated with each other when the discharge voltage is held at a predetermined voltage value, and
the capacity estimation unit performs a fourth estimation process of estimating the battery capacity on a basis of the third output power value, the predetermined voltage value, and the second discharge characteristic information.

21. The battery capacity estimation device according to claim 20, further comprising:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a second discharge mode in which the discharge voltage is held at the predetermined voltage value,
wherein the capacity estimation unit performs the fourth estimation process when the second discharge mode is determined.

22. The battery capacity estimation device according to claim 20, further comprising:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine whether the discharge mode is a first discharge mode in which the discharge current is held at the predetermined current value or a second discharge mode in which the discharge voltage is held at the predetermined voltage value,
wherein the capacity estimation unit performs the third estimation process when the first discharge mode is determined, and performs the fourth estimation process when the second discharge mode is determined.

23. The battery capacity estimation device according to claim 16, wherein
the characteristic information acquisition unit acquires second discharge characteristic information that is the discharge characteristic information in which the discharge current and the battery capacity are associated with each other when the discharge voltage is held at a predetermined voltage value,
the capacity estimation unit performs a fourth estimation process of estimating the battery capacity on a basis of the third output power value, the predetermined voltage value, and the second discharge characteristic information,
the battery capacity estimation device comprises:
a first output current value acquisition unit configured to acquire a first output current value output from the storage battery in second discharging in which the storage battery is discharged over a predetermined time necessary for determining a discharge mode for discharging the storage battery; and
a mode determination unit configured to compare the first output current value with a predetermined threshold and determine that the discharge mode is a first discharge mode in which the discharge current is held at the predetermined current value, and
the capacity estimation unit performs the third estimation process when the first discharge mode is determined.

24. The battery capacity estimation device according to any one of claims 15 to 23, further comprising
a characteristic identification information acquisition unit configured to acquire characteristic identification information associated with each of a plurality of pieces of the discharge characteristic information,
wherein the characteristic information acquisition unit acquires the discharge characteristic information specified by the characteristic identification information.

25. A discharge schedule generation device that generates a discharge schedule for discharging a storage battery, the discharge schedule generation device comprising:
a characteristic information acquisition unit configured to acquire discharge characteristic information of the storage battery in which at least one of a discharge current, a discharge voltage, or a discharge power discharged from the storage battery is associated with battery capacity of the storage battery;
a third output power value acquisition unit configured to acquire a third output power value output from the storage battery in first discharging in which the storage battery is discharged over a predetermined time necessary for estimating the battery capacity;
a capacity estimation unit configured to perform an estimation process of estimating the battery capacity on a basis of at least the third output power value;
a condition acquisition unit configured to acquire a condition related to a discharge time for discharging the storage battery and/or a condition including a target power to be a target during discharging; and
a discharge schedule generation unit configured to generate a discharge schedule on a basis of the battery capacity estimated and the condition.

26. A discharge schedule generation device that generates a discharge schedule for discharging a storage battery, the discharge schedule generation device comprising:
a characteristic information acquisition unit configured to acquire charge characteristic information of the storage battery in which at least one of a charge current, a charge voltage, or a charge power for charging the storage battery is associated with battery capacity of the storage battery;
a capacity estimation unit configured to perform an estimation process of outputting power of a first output power value to the storage battery over a predetermined time necessary for estimating the battery capacity to perform first charging and estimating the battery capacity on a basis of at least the first output power value;
a condition acquisition unit configured to acquire a condition related to a discharge time for discharging the storage battery and/or a condition including a target power to be a target during discharging; and
a discharge schedule generation unit configured to generate a discharge schedule on a basis of the battery capacity estimated and the condition.

27. A battery capacity estimation method for estimating battery capacity of a storage battery, the battery capacity estimation method comprising:
a discharge characteristic information acquisition step of acquiring discharge characteristic information of the storage battery in which at least one of a discharge current, a discharge voltage, or a discharge power discharged from the storage battery is associated with battery capacity;
a first discharge step of discharging the storage battery over a predetermined time necessary for estimating the battery capacity;
a third output power value acquisition step of acquiring a third output power value output from the storage battery in the first discharge step; and
a capacity estimation step of performing at least an estimation process of estimating the battery capacity on a basis of the third output power value.
